# EUROPEAN PATENT APPLICATION

(11) **EP 4 503 100 A1**
(43) Date of publication of application: **05.02.2025**
(21) Application number: 23780758.1
(22) Date of filing: 29.03.2023
(51) Int. Cl.: H01L 21/312

(54) **POLYMER FILM-FORMING COMPOSITION AND SELECTIVE POLYMER FILM-FORMING METHOD**

(30) Priority: 31.03.2022 JP 2022059659
(71) Applicant: Nissan Chemical Corporation, Tokyo 103-6119 (JP)
(72) Inventor: USUI, Yuki, Toyama-shi, Toyama 939-2753 (JP); KISHIOKA, Takahiro, Toyama-shi, Toyama 939-2753 (JP)
(74) Representative: Hoffmann Eitle
(86) International application number: PCT/JP2023/012963
(87) International publication number: WO 2023/190750

(57) **Abstract**

[Problem] To provide a substance which makes it possible to selectively mask according to the substrate surface material. [Solution] Provided are: a polymer film-forming composition for selectively forming a polymer film on a region (R-I) of a substrate which has said region (R-I), the surface of which comprises a metal (I), and a region (R-II), the surface of which comprises a material (II) which differs from the metal (I), said polymer film-forming composition comprising a radical generator (A) and a radical-equipped reactive compound (B); and a selective polymer film formation method for forming a film of said polymer film-forming composition on the surface of the substrate.

## Description

### TECHNICAL FIELD

The present invention relates to a polymer film-forming composition, for example, a polymer film-forming composition which is useful in the production of a semiconductor integrated circuit and the like and which allows a film to be selectively formed depending on the material of a substrate surface, and a selective polymer film-forming method using the polymer film-forming composition.

### BACKGROUND ART

In recent years, there has been an increasing trend toward higher integration and miniaturization of semiconductor devices, and refinement of organic patterns serving as masks used during device production and refinement of inorganic patterns produced by the subsequent etching processing have progressed, and as a result, there is a demand for film thickness control at the atomic layer level.

As a method of forming a thin film on a substrate at the atomic layer level, an atomic layer deposition (ALD) method (also known as an atomic layer growth method) is known. The ALD method is classified as a type of general chemical vapor deposition (CVD) method, and is known to have both high step coverage and film thickness controllability compared to other CVD methods.

The ALD method is a thin film formation technique in which two types of gases, with elements that constitute a film to be formed as main components, are alternately supplied onto a substrate, and a process of forming a thin film on the substrate at the atomic layer unit is repeated a plurality of times to form a film with a desired thickness.

In the ALD method, while a source gas is supplied, only one or a few layers of source gas components are adsorbed on the surface of the substrate, excess source gas does not contribute to growth, and a self-control function (self-limiting function) of growth is used.

For example, when an Al₂O₃ film is formed on a substrate, a source gas composed of TMA (trimethylaluminum) and an oxidizing gas containing an oxygen atom (O) are used. In addition, when a nitride film is formed on a substrate, a nitriding gas is used in place of an oxidizing gas.

In recent years, a method of selectively depositing a layer on the surface of a substrate using the ALD method, that is, a region-selective film-forming method, has been proposed (for example, Patent Document 1, etc.).

In addition, a method of region-selectively modifying a substrate surface so that it can be suitably applied to a method of forming a region-selective film on a substrate by the ALD method has been proposed (for example, Patent Document 2, etc.).

### Prior Art Documents

### Patent Document

Patent Document 1: Japanese Patent No. 4043785
Patent Document 2: JP 2019-121777 A

### SUMMARY OF THE INVENTION

### Problem to be Solved by the Invention

As described above, in recent years, as semiconductor devices have become fine and mask patterns have become finer accordingly, the masking method using resists and the like using a photolithography technology that has been used during production of semiconductor devices has developed a problem of a large number of steps and lithography precision.

An object of the present invention is to provide a material which can selectively perform masking according to a material of a substrate surface, which can be applied to a region-selective film-forming method using the ALD method.

### Means for Solving the Problem

The inventors found that, when a radical addition reactive compound and a specific radical generator are combined, a polymer film can be selectively formed depending on a material of a substrate surface, and completed the present invention.

Specifically, a first aspect of the present invention relates to a polymer film-forming composition for selectively forming, on a substrate having a surface including a region (R-I) made of a metal (I) and a region (R-II) made of a material (II) different from the metal (I), a polymer film on the region (R-I) of the substrate, wherein the polymer film-forming composition contains a radical generator (A) and a radical addition reactive compound (B).

A second aspect relates to a polymer film-forming composition for selectively forming, on a substrate having a surface including a region (R-I) made of a metal (I) and a region (R-II) made of a material (II) different from the metal (I), a polymer film on the region (R-I) of the substrate, wherein the polymer film-forming composition contains a radical generator (A) and a radical addition reactive compound (B), and wherein the polymer film-forming composition is composed of a component composition having a higher curability on the region (R-I) than on the region (R-II) when heated on the substrate.

A third aspect relates to the polymer film-forming composition according to the first aspect or the second aspect, wherein the radical generator (A) is a radical generator containing a sulfur atom.

A fourth aspect relates to the polymer film-forming composition according to any one of the first aspect to the third aspect, wherein the radical generator (A) is an oxime ester-based radical generator.

A fifth aspect relates to the polymer film-forming composition according to any one of the first aspect to the fourth aspect, wherein the radical generator (A) is a radical generator of the following Formula (1). 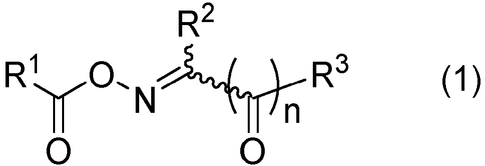 [wherein,
each of R¹ and R³ is independently a substitutable phenyl group, a substitutable 5-to 10-membered aromatic heterocyclic group, or a substitutable C₁₋₁₀ alkyl group, and a substituent for the phenyl group, aromatic heterocyclic group, or alkyl group arbitrarily contains a sulfur atom,
R² is a hydrogen atom or a substitutable C₁₋₁₀ alkyl group, and a substituent for the alkyl group arbitrarily contains a sulfur atom,
n is 0 or 1,
a wavy line indicates either an E geometrical isomer or a Z geometrical isomer, or a mixture of the E geometrical isomer and the Z geometrical isomer].

A sixth aspect relates to the polymer film-forming composition according to any one of the first aspect to the fifth aspect, wherein the radical addition reactive compound (B) is at least one polymer selected from the group consisting of a polyimide, a polyamic acid, and a polyamic acid ester, each of which has a radical addition reactive double bond in a molecule.

A seventh aspect relates to the polymer film-forming composition according to any one of the first aspect to the sixth aspect, wherein the radical addition reactive compound (B) is at least one selected from among polyimide precursors having a unit structure of the following Formula (2): 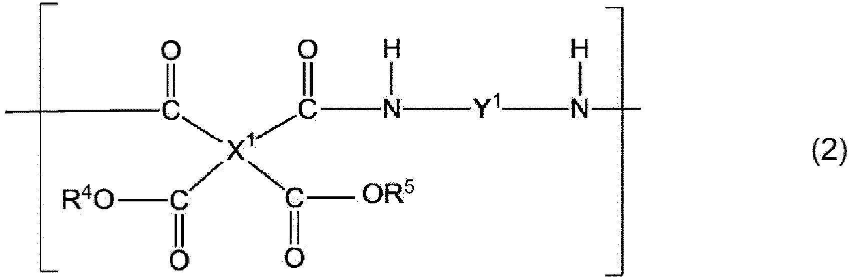 [wherein,
X¹ is a tetravalent organic group, and Y¹ is a divalent organic group, and
each of R⁴ and R⁵ is independently a hydrogen atom or a monovalent organic group, provided that at least one of R⁴ and R⁵ is a group of Formula (3)] 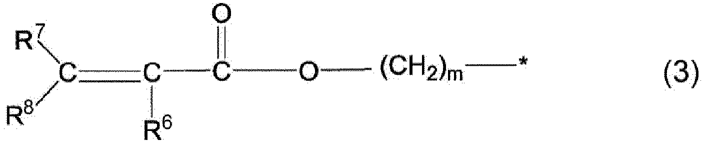 [wherein, each of R⁶, R⁷ and R⁸ is independently a hydrogen atom or a C₁₋₃ monovalent organic group, m is an integer of 1 to 10, and * indicates a bonding site with an oxygen atom in Formula (2)].

An eighth aspect relates to the polymer film-forming composition according to any one of the first aspect to the fifth aspect, wherein the radical addition reactive compound (B) is at least one selected from the group consisting of a (meth)acrylate compound and a vinyl compound.

A ninth aspect relates to the polymer film-forming composition according to any one of the first aspect to the eighth aspect, wherein the metal (I) is copper, an alloy containing copper, titanium or an alloy containing titanium.

A tenth aspect relates to the polymer film-forming composition according to any one of the first aspect to the ninth aspect, wherein the material (II) is at least one selected from the group consisting of SiO₂, SiN, SiC, SiOC, SiCN, Ta, TaN, Ti, and TiN.

An eleventh aspect relates to a selective polymer film-forming method in which a polymer film is formed on a surface of a substrate, the surface having a region (R-I) made of a metal (I) and a region (R-II) that is adjacent to the region (R-I) and made of a material (II) different from the metal (I), the selective polymer film-forming method comprising:
a polymer film forming step in which a polymer film-forming composition containing a radical generator (A) and a radical addition reactive compound (B) is applied to the surface and heated to form a polymer film; and subsequently
a step in which the surface of the substrate is brought into contact with a solvent (C), and a coating on the region (R-II) is removed.

A twelfth aspect relates to the selective polymer film-forming method according to the eleventh aspect, further comprising a residue removal step in which a residue on the region (R-II) is removed by dry etching after the step of removing the coating on the region (R-II).

A thirteenth aspect relates to a thin film-forming method of selectively forming, on a substrate having a region (R-I) made of a metal (I) and a region (R-II) made of a material (II) different from the metal (I), a thin film on the region (R-II) by an atomic layer deposition method, the thin film-forming method comprising,
a step of forming a thin film by an atomic layer deposition method on the surface of the substrate on which a polymer film is formed on the region (R-I) by the selective polymer film-forming method according to the eleventh aspect or the twelfth aspect.

A fourteenth aspect relates to the thin film-forming method according to the thirteenth aspect, further comprising a step of removing the polymer film on the region (R-I) made of the metal (I) after the step of forming the thin film.

A fifteenth aspect relates to a laminate having a plurality of regions formed on a surface of a substrate,
wherein each of the regions has a region (R-I) made of a metal (I) and a region (R-II) that is adjacent to the region (R-I) and made of a material (II) different from the metal (I),
wherein a polymer film formed from the polymer film-forming composition according to any one of the first aspect to the tenth aspect is provided on the region (R-I), and
wherein the polymer film is not provided on the region (R-II).

### Effects of the Invention

According to the present invention, it is possible to provide a polymer film-forming composition which allows a polymer film to be selectively formed on a substrate surface having a plurality of regions, particularly, made of different materials, depending on a material of the substrate surface, and a selective film-forming method.

In addition, according to the present invention, it is possible to provide a laminate (substrate) on which a polymer film is region-selectively formed, which can be particularly applied for region-selective film formation on a substrate surface using an atomic layer deposition method (ALD method).

### BRIEF DESCRIPTION OF THE DRAWINGS

[FIG. 1] FIG. 1 shows scanning electron microscope images of a vertical cross section of an (untreated) substrate used in Film Formation Example 3.
[FIG. 2] FIG. 2 shows scanning electron microscope images of a vertical cross section of the substrate produced in Film Formation Example 3.

### MODES FOR CARRYING OUT THE INVENTION

The present invention relates to a polymer film-forming composition which allows a film to be selectively formed depending on the material of a substrate surface, and a selective polymer film-forming method using the polymer film-forming composition.

### [Substrate]

A substrate to which the polymer film-forming composition and the selective polymer film-forming method of the present invention are applied has a surface including a region (R-I) made of a metal (I) and a region (R-II) made of a material (II) different from the metal (I).

The metal (I) is preferably copper, an alloy containing copper, titanium or an alloy containing titanium.

In addition, the material (II) is preferably at least one selected from the group consisting of SiO₂, SiN, SiC, SiOC, SiCN, Ta, TaN, Ti, and TiN.

Here, the "surface" of the substrate refers to the "surface" of the substrate itself as well as the "surface" of a layer or a pattern made of the metal (I) or the material (II) provided on the substrate.

In addition, on the same substrate, the region (R-I) and the region (R-II) may each have a plurality of regions (R-I) and regions (R-II) made of different metal species/material species.

### [Polymer film-forming composition]

The polymer film-forming composition according to the present invention contains a radical generator (A) and a radical addition reactive compound (B), and may contain other components as desired.

The polymer film-forming composition according to the present invention may be composed of a component composition that has a higher curability on the region (R-I) than on the region (R-II) when heated on the substrate.

### «Radical generator (A)»

As the radical generator (A) used in the polymer film-forming composition of the present invention, for example, a radical generator containing a sulfur atom can be used.

As the radical generator (A), for example, an oxime ester-based radical generator can be used.

The oxime ester-based radical generator is generally used as a photoradical polymerization generator during photopolymerization and UV curing. As will be described below, the present invention is characterized in that the composition is thermally cured to obtain a polymer film, that is, the oxime ester-based radical generator is used as a thermal radical polymerization generator.

As the radical generator (A), for example, a radical generator of the following Formula (1) can be used. 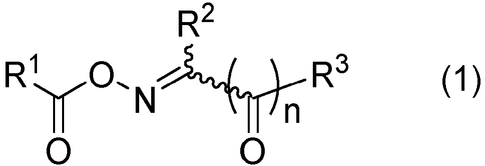
In Formula (1), each of R¹ and R³ is independently a substitutable phenyl group, a substitutable 5- to 10-membered aromatic heterocyclic group, a substitutable C₁₋₁₀ alkyl group, and a substituent for the phenyl group, aromatic heterocyclic group, or alkyl group arbitrarily contains a sulfur atom,
R² is a hydrogen atom or a substitutable C₁₋₁₀ alkyl group, and a substituent for the alkyl group arbitrarily contains a sulfur atom,
n is 0 or 1, and
a wavy line indicates either an E geometrical isomer or a Z geometrical isomer, or a mixture of the E geometrical isomer and the Z geometrical isomer.

Examples of C₁₋₁₀ alkyl groups include a linear or branched alkyl group having a carbon atom number of 1 to 10, for example, a methyl group, ethyl group, n-propyl group, i-propyl group, n-butyl group, i-butyl group, s-butyl group, t-butyl group, n-pentyl group, 1-methyl-n-butyl group, 2-methyl-n-butyl group, 3-methyl-n-butyl group, 1,1-dimethyl-n-propyl group, 1,2-dimethyl-n-propyl group, 2,2-dimethyl-n-propyl group, 1-ethyl-n-propyl group, n-hexyl group, 1-methyl-n-pentyl group, 2-methyl-n-pentyl group, 3-methyl-n-pentyl group, 4-methyl-n-pentyl group, 1,1-dimethyl-n-butyl group, 1,2-dimethyl-n-butyl group, 1,3-dimethyl-n-butyl group, 2,2-dimethyl-n-butyl group, 2,3-dimethyl-n-butyl group, 3,3-dimethyl-n-butyl group, 1-ethyl-n-butyl group, 2-ethyl-n-butyl group, 1,1,2-trimethyl-n-propyl group, 1,2,2-trimethyl-n-propyl group, 1-ethyl-1-methyl-n-propyl group and 1-ethyl-2-methyl-n-propyl group.

In addition, cyclic alkyl groups may also be used, and examples of C₃₋₁₀ cyclic alkyl groups include cycloalkyl groups such as a cyclopropyl group, cyclobutyl group, 1-methyl-cyclopropyl group, 2-methyl-cyclopropyl group, cyclopentyl group, 1-methyl-cyclobutyl group, 2-methyl-cyclobutyl group, 3-methyl-cyclobutyl group, 1,2-dimethyl-cyclopropyl group, 2,3-dimethyl-cyclopropyl group, 1-ethyl-cyclopropyl group, 2-ethyl-cyclopropyl group, cyclohexyl group, 1-methyl-cyclopentyl group, 2-methyl-cyclopentyl group, 3-methyl-cyclopentyl group, 1-ethyl-cyclobutyl group, 2-ethyl-cyclobutyl group, 3-ethyl-cyclobutyl group, 1,2-dimethyl-cyclobutyl group, 1,3-dimethyl-cyclobutyl group, 2,2-dimethyl-cyclobutyl group, 2,3-dimethyl-cyclobutyl group, 2,4-dimethyl-cyclobutyl group, 3,3-dimethyl-cyclobutyl group, 1-n-propyl-cyclopropyl group, 2-n-propyl-cyclopropyl group, 1-i-propyl-cyclopropyl group, 2-i-propyl-cyclopropyl group, 1,2,2-trimethyl-cyclopropyl group, 1,2,3-trimethyl-cyclopropyl group, 2,2,3-trimethyl-cyclopropyl group, 1-ethyl-2-methyl-cyclopropyl group, 2-ethyl-1-methyl-cyclopropyl group, 2-ethyl-2-methyl-cyclopropyl group and 2-ethyl-3-methyl-cyclopropyl group, and crosslinked ring type cycloalkyl groups such as a bicyclobutyl group, bicyclopentyl group, bicyclohexyl group, bicycloheptyl group, bicyclooctyl group, bicyclononyl group and bicyclodecyl group.

Examples of 5- to 10-membered aromatic heterocyclic groups include a furan group, pyrrole group, imidazole group, imidazoline group, thiophene group, pyrazole group, oxazole group, isooxazole group, thiazole group, isothiazole group, pyridine group, pyrazine group, pyrimidine group, pyridazine group, triazine group, benzofuran group, indole group, indolizine group, isoindole group, benzothiophene group, benzoimidazole group, purine group, quinoline group, isoquinoline group, quinoxaline group, quinazoline group, cinnoline group, and benzopyran group.

In addition, examples of substituents for the phenyl group, aromatic heterocyclic group, and alkyl group include a halogen atom, alkyl group, phenyl group, hydroxy group, carboxy group, epoxy group, acryloyl group, methacryloyl group, mercapto group, alkylthio group, arylthio group, heterocyclic thio group, sulfonyl group, alkylsulfonyl group, arylsulfonyl group, heterocyclic sulfonyl group, amino group, amide group, alkoxy group, and cyano group. The phenyl group, aromatic heterocyclic group, and alkyl group may have two or more of these substituents or may have two or more of these substituents in combination as one substituent.

Specific examples of the radical generator (A) include, although not being limited to, for example, 1-[4-(phenylthio)phenyl]-1,2-octanedione-2-(O-benzoyl oxime) (Irgacure (registered trademark) OXE01, commercially available from BASF Japan), 5-(4-isopropylphenylthio)-1,2-indandione, 2-O-acetyl)oxime (OMNIRAD 1312, commercially available from IGM RESINS), 1-[4-(phenylthio)phenyl]-3-cyclopentylpropane-1,2-dione-2-(O-benzoyl oxime), and compounds of the following formula (Adeka Arkls NCI-930, commercially available from ADEKA Corporation).

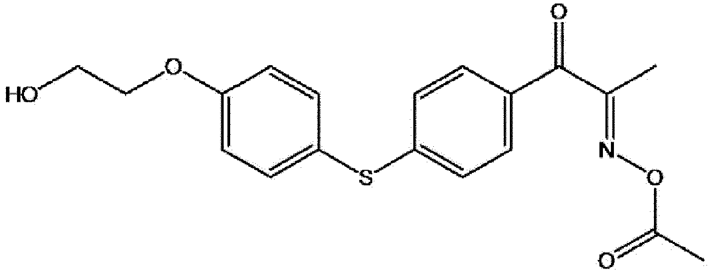

### <<Radical addition reactive compound (B)>>

The radical addition reactive compound (B) used in the polymer film-forming composition of the present invention is, for example, a compound having at least one radical addition reactive double bond in the molecule, and preferably a compound having two or more radical addition reactive double bonds in the molecule can be used.

Examples of the radical addition reactive compound (B) include a polymer having a radical addition reactive double bond in the molecule (for example, a polyimide, a polyamic acid, and a polyamic acid ester), a (meth)acrylate compound and a vinyl compound, but the present invention is not limited thereto.

In addition, the radical addition reactive compounds (B) may be used alone or two or more thereof may be used in combination.

Examples of the radical addition reactive compound (B) include polyimide precursors having a unit structure of the following Formula (2). 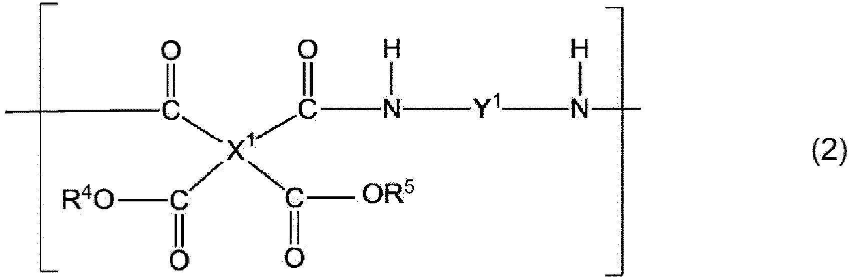
In Formula (2), X¹ is a tetravalent organic group, and Y¹ is a divalent organic group, and
each of R⁴ and R⁵ is independently a hydrogen atom or a monovalent organic group, provided that at least one of R⁴ and R⁵ is a group of the following Formula (3).

X¹ is not particularly limited as long as it is a tetravalent organic group, and examples thereof include a C₆₋₄₀ tetravalent organic group. More specific examples thereof include tetravalent organic groups which contain an aromatic ring and/or aliphatic ring, and preferably 2 to 8 aromatic rings and/or aliphatic rings, and which may contain at least one ether bond (-O-) or ester bond (-COO-, -OCO-) linking them.

For example, X¹ may be a tetravalent organic group of the following Formula (4) or Formula (5).

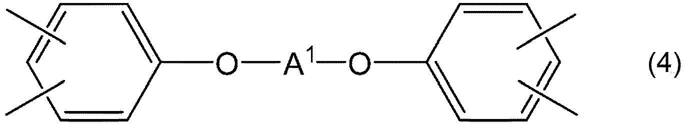

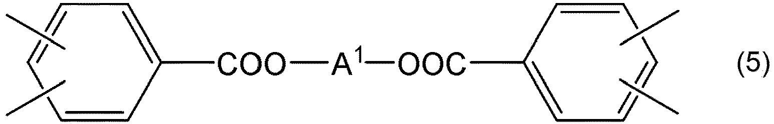

In the formulae, A¹ and A² are a divalent organic group containing a C₆₋₄₀ aromatic ring and/or aliphatic ring which are directly bonded or a divalent organic group containing a C₆₋₄₀ aromatic ring and/or aliphatic ring, which may be substituted with a halogen atom or may form a ring and having an intervening alkylene group, -CO-, -COO-, -OCO-, or -O-.

A¹ and A² are more preferably a divalent organic group containing a C₆₋₄₀ aromatic ring and/or aliphatic ring which are directly bonded or a divalent organic group containing a C₆₋₄₀ aromatic ring and/or aliphatic ring having an intervening C₂₋₄ alkylene group which may be substituted with a halogen atom or may form a ring, and still more preferably a divalent organic group containing a C₆₋₄₀ aromatic ring having an intervening C₂₋₄ alkylene group.

Examples of X¹ include various tetravalent groups shown in the groups of the following Formula (6) and tetravalent groups of Formulae (6-1) to (6-14). Here, in each formula, * indicates a bond to a carbon atom of a carbonyl group in Formula (2).

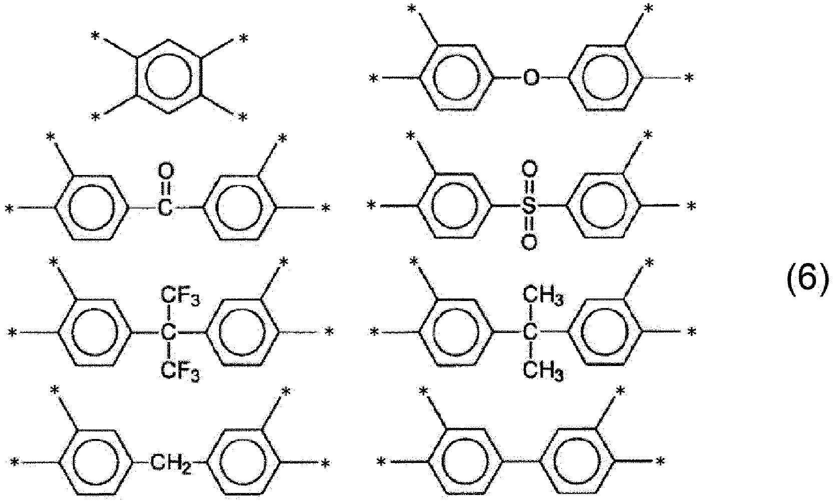

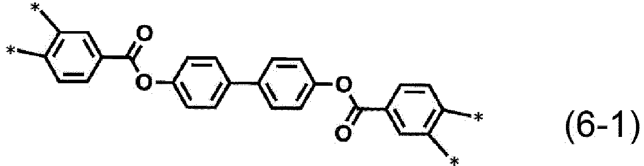

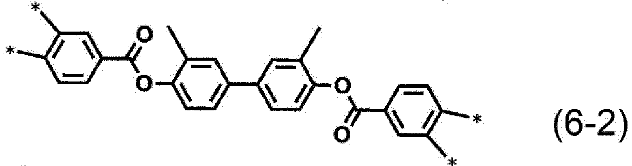

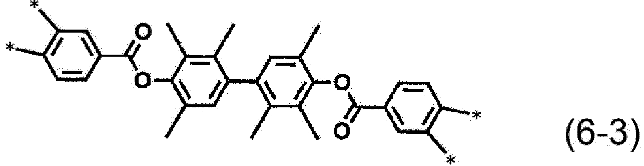

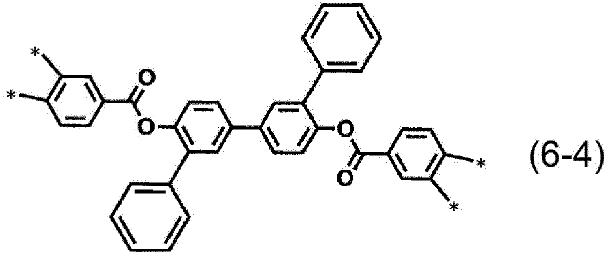

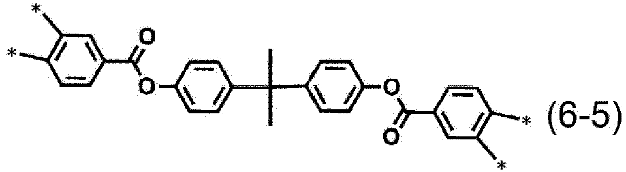

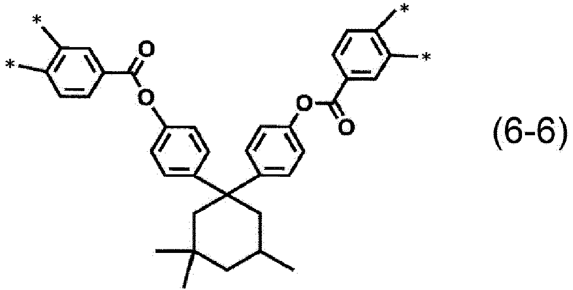

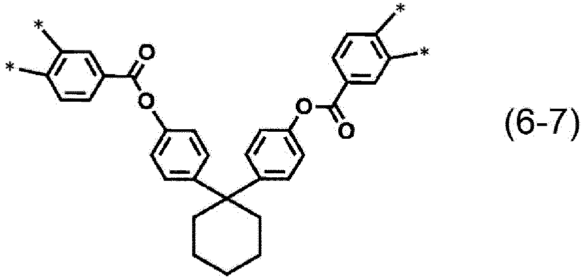

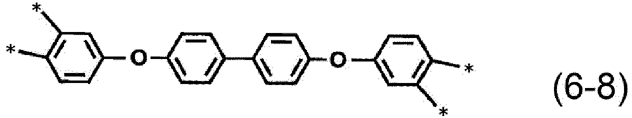

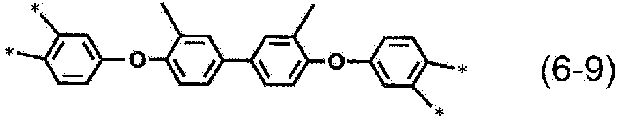

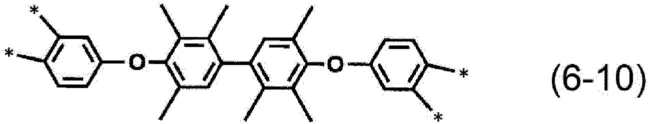

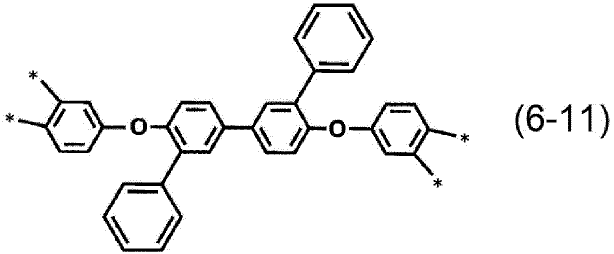

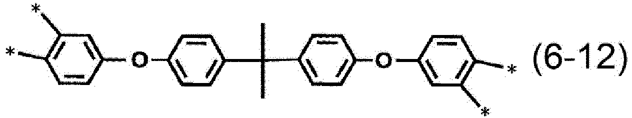

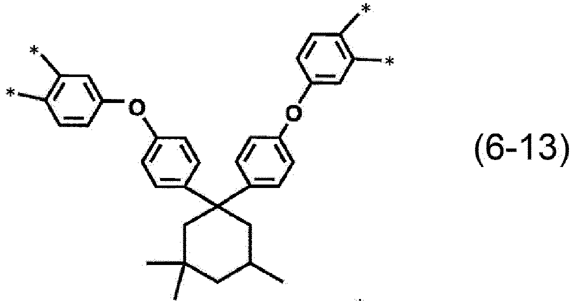

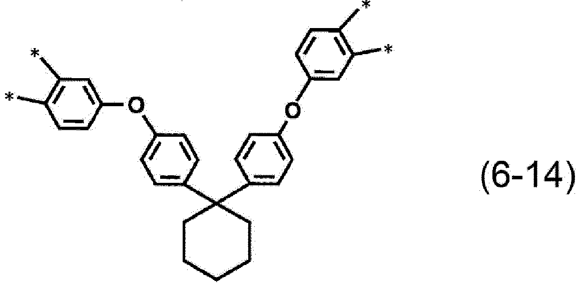

The structure of X¹ may be of one type or a combination of two or more types.

Y¹ is not particularly limited as long as it is a divalent organic group, and examples thereof include a C₆₋₄₀ divalent organic group.

More specific examples thereof include divalent organic groups containing an aromatic ring and/or aliphatic ring, for example, 1 to 8 aromatic rings and/or aliphatic rings which may be substituted, and divalent aliphatic groups and siloxane groups which have no cyclic structure.

Examples of Y¹ include various divalent groups shown in the groups of the following Formula (7) to Formula (9). Here, in the formulae, each A is independently an alkyl group such as a methyl group, an ethyl group, a propyl group, or a butyl group. In addition, in each formula, * indicates a bond to a nitrogen atom in Formula (2).

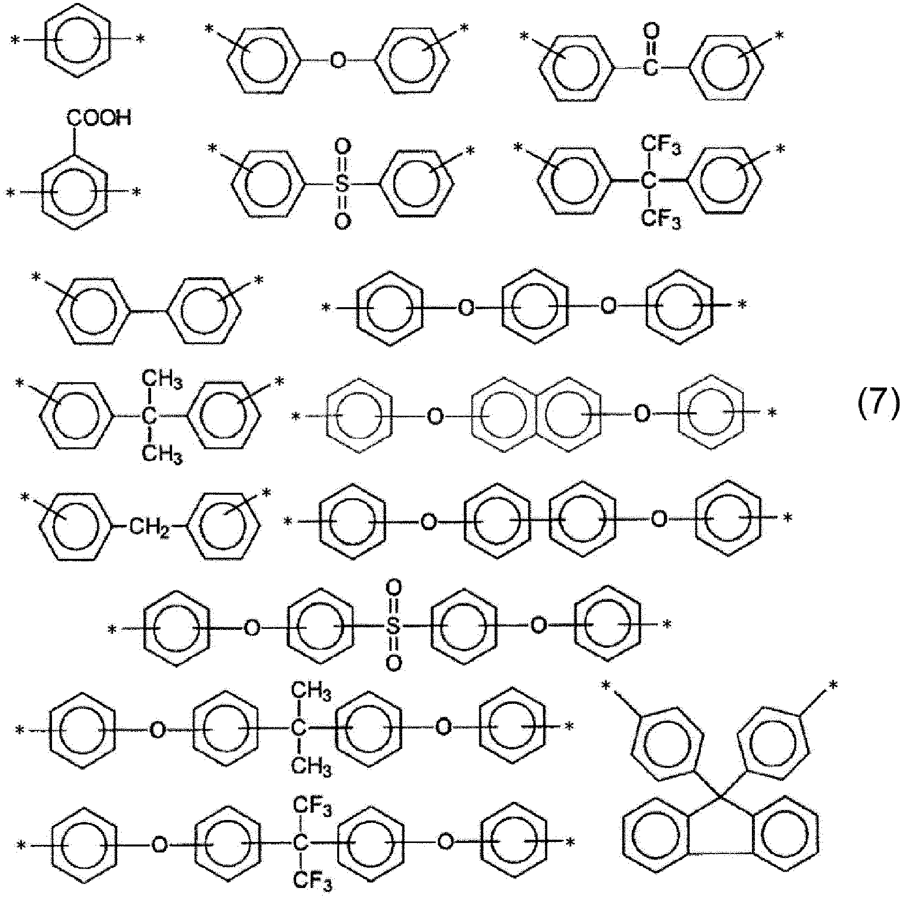

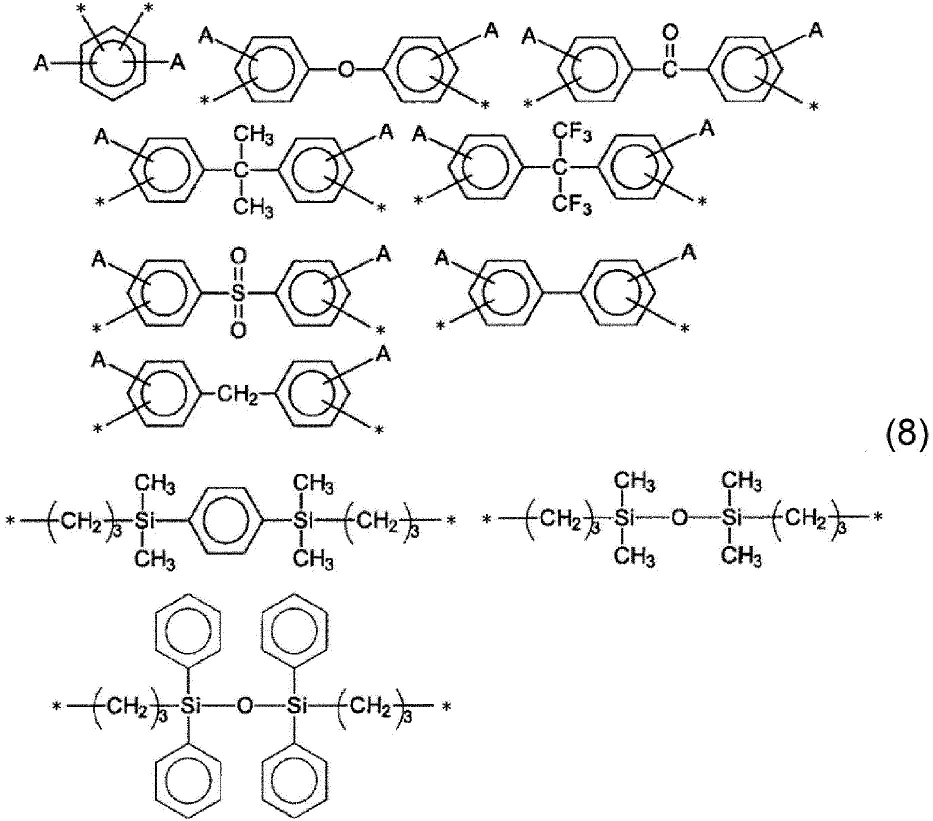

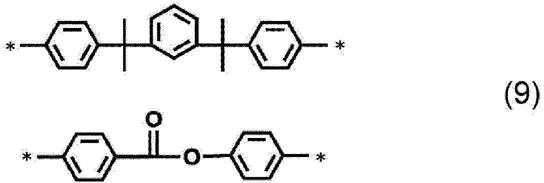

The structure of Y¹ may be of one type or a combination of two or more types.

Each of R⁴ and R⁵ is independently a hydrogen atom or a monovalent organic group, provided that either R⁵ or R⁶ is a group of the following Formula (3).

The monovalent organic group is not particularly limited, and examples thereof include a C₁₋₃₀ or C₅₋₂₂ monovalent aliphatic group, a cycloaliphatic group, a group in which an aromatic group and an aliphatic group are bonded, and groups in which such a group is substituted with a halogen atom, a nitro group, an amino group, a cyano group, a methoxy group, or an acetoxy group. Examples of halogen atoms include a fluorine atom, a chlorine atom, a bromine atom, and an iodine atom.

As described above, at least one of R⁴ and R⁵ is a monovalent organic group of the following Formula (3), or both R⁴ and R⁵ may be a monovalent organic group of Formula (3). For example, the amount of the monovalent organic group of Formula (3) with respect to a total amount of R⁴ and R⁵ may be 50 mol% or more or 80 mol% or more.

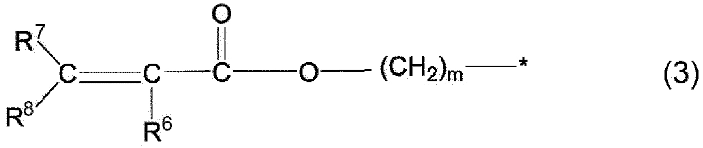

In Formula (3), each of R⁶, R⁷ and R⁸ is independently a hydrogen atom or a C₁₋₃ monovalent organic group, m is an integer of 1 to 10, and * indicates a bonding site with an oxygen atom in Formula (2).

Examples of C₁₋₃ monovalent organic groups include linear alkyl groups such as a methyl group, an ethyl group, and a propyl group; branched alkyl groups such as an isopropyl group; alicyclic alkyl groups such as a cyclopropyl group; alkenyl groups such as a vinyl group and an allyl group; alkynyl groups such as an ethynyl group; alkoxy groups such as a methoxy group, an ethoxy group, and a propoxy group; acyl groups such as an acetyl group; ester groups such as a methoxycarbonyl group; formyl groups; haloformyl groups; carbamoyl groups; cyano groups; and heterocyclic groups such as an oxiranyl group, an aziridinyl group, a thietanyl group, a triazinyl group, an oxathiolanyl group, a dihydroazetyl group, and a dihydrothiazolyl group.

R⁶ in Formula (3) is not limited as long as it is a hydrogen atom or a C₁₋₃ monovalent organic group, and may be, for example, a hydrogen atom or a methyl group.

In addition, R⁷ and R⁸ are not limited as long as they are each independently a hydrogen atom or a C₁₋₃ monovalent organic group, and may be, for example, a hydrogen atom.

In addition, m is preferably an integer of 2 or more and 4 or less.

The polyimide precursor having a unit structure of Formula (2) can be converted into a polyimide by performing a heat cyclization treatment.

An example of a method of preparing a polyimide precursor having a unit structure of Formula (2) is as follows.

For example, a partially esterified tetracarboxylic acid (hereinafter referred to as an acid component/ester component) is prepared by reacting a tetracarboxylic dianhydride containing the tetravalent organic group X¹ with an alcohol in which a monovalent organic group of Formula (3) and a hydroxy group are bonded, and then polycondensed with a diamine containing the divalent organic group Y¹ to obtain a polyimide precursor having a unit structure of Formula (2).

### (Preparation of acid component/ester component)

Examples of tetracarboxylic dianhydrides containing the tetravalent organic group X¹ include a pyromellitic anhydride, diphenyl-3,3',4,4'-tetracarboxylic dianhydride (=4,4'-biphthalic dianhydride), diphenyl ether-3,3',4,4'-tetracarboxylic dianhydride (=4,4'-oxydiphthalic acid dianhydride), benzophenone-3,3',4,4'-tetracarboxylic dianhydride, biphenyl-3,3',4,4'-tetracarboxylic dianhydride, diphenylsulfone-3,3',4,4'-tetracarboxylic dianhydride, diphenylmethane-3,3',4,4'-tetracarboxylic dianhydride, 2,2-bis(3,4-phthalic anhydride)propane, and 2,2-bis(3,4-phthalic anhydride)-1,1,1,3,3,3-hexafluoropropane.

In addition, tetracarboxylic dianhydrides of the following Formula (6-1-a) to Formula (6-14-a) may be exemplified.

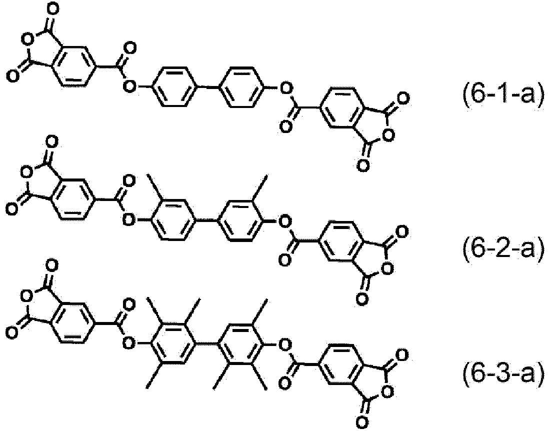

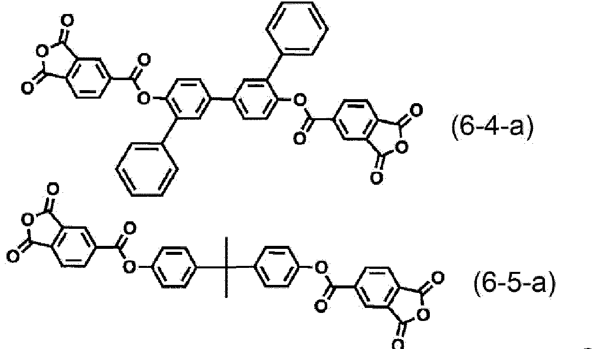

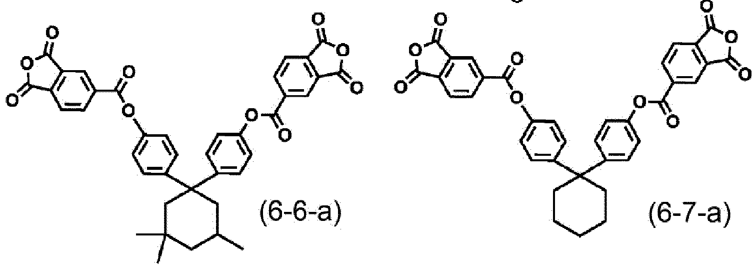

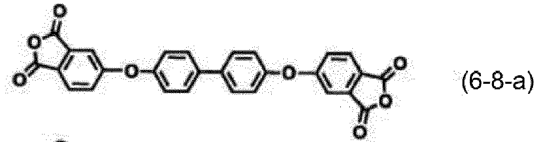

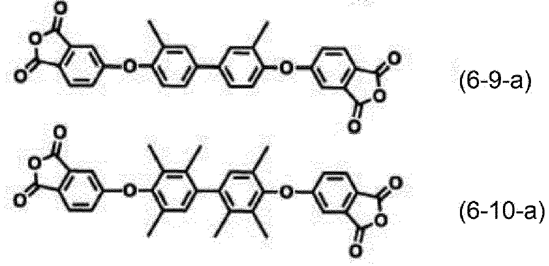

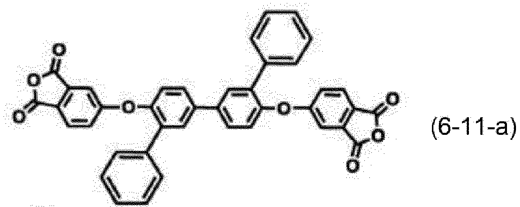

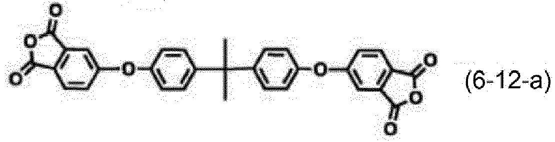

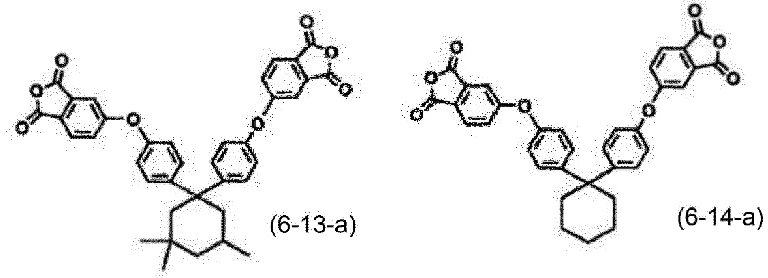

These may be used alone or two or more thereof may be used in combination.

Examples of alcohols having the structure of Formula (3) include a 2-acryloyloxyethyl alcohol, 1-acryloyloxy-3-propyl alcohol, methylol vinyl ketone, 2-hydroxyethyl vinyl ketone, 2-hydroxy-3-methoxypropyl acrylate, 2-hydroxy-3-butoxypropyl acrylate, 2-hydroxy-3-butoxypropyl acrylate, 2-methacryloyloxyethyl alcohol, 1-methacryloyloxy-3-propyl alcohol, 2-hydroxy-3-methoxypropyl methacrylate, 2-hydroxy-3-butoxypropyl methacrylate, 2-hydroxy-3-butoxypropyl methacrylate, and 2-hydroxyethyl methacrylate.

In the preparation of the acid component/ester component, it is preferable to use an alcohol having a structure of Formula (3) in an amount adjusted to 80 mol% or more with respect to the total content of R⁴ and R⁵ in Formula (2).

The tetracarboxylic dianhydride and the alcohol are stirred, dissolved and mixed in a reaction solvent in the presence of a basic catalyst such as pyridine at a reaction temperature of 0 to 100°C for 10 to 40 hours, a half-esterification reaction of an acid dianhydride proceeds, and a desired acid component/ester component can be obtained.

The reaction solvent is preferably one that dissolves a polyimide precursor which is a polycondensation product of the acid component/ester component and the acid component/ester component with diamines, and examples thereof include N-methyl-2-pyrrolidone, N,N-dimethylacetamide, N,N-dimethylformamide, dimethyl sulfoxide, tetramethylurea, γ-butyrolactone, ketones, esters, lactones, ethers, halogenated hydrocarbons, hydrocarbons, acetone, methyl ethyl ketone, methyl isobutyl ketone, cyclohexanone, methyl acetate, ethyl acetate, butyl acetate, diethyl oxalate, ethylene glycol dimethyl ether, diethylene glycol dimethylether, tetrahydrofuran, dichloromethane, 1,2-dichloroethane, 1,4-dichlorobutane, chlorobenzene, o-dichlorobenzene, hexane, heptane, benzene, toluene, and xylene. As necessary, these may be used alone or two or more thereof may be used in combination.

### (Preparation of polyimide precursor)

A known dehydrating condensing agent, for example, dicyclohexylcarbodiimide, N,N'-diisopropylcarbodiimide, 1-ethoxycarbonyl-2-ethoxy-1,2-dihydroquinoline, 1,1-carbonyldioxy-di-1,2,3-benzotriazole, or N,N'-disuccinimidyl carbonate, is added to and mixed with the acid component/ester component (typically, a solution in the reaction solvent) under ice cooling to convert the acid component/ester component into a polyanhydride, and a diamine containing the divalent organic group Y¹ dissolved or dispersed in a separate solvent is then added dropwise thereto, the mixture is polycondensed and thereby a polyimide precursor having a unit structure of Formula (2) can be obtained.

Examples of diamines containing the divalent organic group Y¹ include p-phenylenediamine, m-phenylenediamine, 4,4-diaminodiphenyl ether, 3,4'-diaminodiphenyl ether, 3,3'-diaminodiphenyl ether, 4,4'-diaminodiphenyl sulfide, 3,4'-diaminodiphenyl sulfide, 3,3'-diaminodiphenyl sulfide, 4,4'-diaminodiphenylsulfone, 3,4'-diaminodiphenylsulfone, 3,3'-diaminodiphenylsulfone, 4,4'-diaminobiphenyl, 3,4'-diaminobiphenyl, 3,3'-diaminobiphenyl, 4,4'-diaminobenzophenone, 3,4'-diaminobenzophenone, 3,3'-diaminobenzophenone, 4,4'-diaminodiphenylmethane, 3,4'-diaminodiphenylmethane, 3,3'-diaminodiphenylmethane, 1,4-bis(4-aminophenoxy)benzene, 1,3-bis(4-aminophenoxy)benzene, 1,3-bis(3-aminophenoxy)benzene, bis[4-(4-aminophenoxy)phenyl]sulfone, bis[4-(3-aminophenoxy)phenyl]sulfone, 4,4'-bis(4-aminophenoxy)biphenyl, 4,4-bis(3-aminophenoxy)biphenyl, bis[4-(4-aminophenoxy)phenyl]ether, bis[4-(3-aminophenoxy)phenyl]ether, 1,4-bis(4-aminophenyl)benzene, 1,3-bis(4-aminophenyl)benzene, 9,10-bis(4-aminophenyl)anthracene, 2,2-bis(4-aminophenyl)propane, 2,2-bis(4-aminophenyl)hexafluoropropane, 2,2-bis[4-(4-aminophenoxy)phenyl]propane, 2,2-bis[4-(4-aminophenoxy)phenyl]hexafluoropropane, 1,4-bis(3-aminopropyldimethylsilyl)benzene, ortho-tolidine sulfone, 9,9-bis(4-aminophenyl)fluorene, those in which some hydrogen atoms on these benzene rings are substituted with a methyl group, an ethyl group, a hydroxymethyl group, a hydroxyethyl group, a halogen or the like, for example, 3,3'-dimethyl-4,4'-diaminobiphenyl, 2,2'-dimethyl-4,4'-diaminobiphenyl, 3,3'-dimethyl-4,4'-diaminodiphenylmethane, 2,2'-dimethyl-4,4'-diaminodiphenylmethane, 3,3'-dimethoxy-4,4'-diaminobiphenyl, 3,3'-dichloro-4,4'-diaminobiphenyl, and mixtures thereof.

In addition, diamines shown in the groups of the following Formula (9-1) may be exemplified.

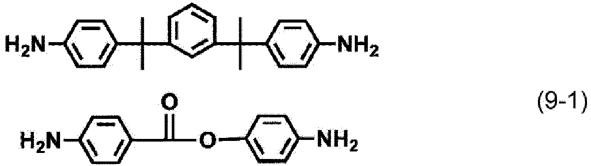

The diamines are not limited thereto.

After the polycondensation reaction is completed, the water-absorbing by-product of the dehydrating condensing agent coexisting in the reaction solution is filtered off as necessary, a poor solvent such as water, a lower aliphatic alcohol, or a mixed solution thereof is then added to the reaction solution to precipitate a polymer component, redissolution and reprecipitation operations are additionally repeated to purify the polymer, vacuum-drying is performed, and a polyimide precursor having a unit structure of Formula (2) can be isolated. In order to improve the degree of purification, the polymer solution may be passed through a column filled with an anion and/or cation exchange resin swollen with an appropriate organic solvent to remove ionic impurities.

When the weight average molecular weight in terms of polystyrene is measured by gel permeation chromatography, the molecular weight of the polyimide precursor having a unit structure of Formula (2) may be, for example, 5,000 to 150,000, or for example, 7,000 to 50,000.

In addition, examples of the radical addition reactive compound (B) include a (meth)acrylate compound and a vinyl compound. Here, the (meth)acrylate compound and the vinyl compound are distinguished from a polyimide, a polyamic acid, and a polyamic acid ester, each of which has a radical addition reactive double bond in the molecule and a polyimide precursor having a unit structure of Formula (2).

These (meth)acrylate compounds or vinyl compounds may be used alone or two or more thereof may be used in combination. In addition, the (meth)acrylate compound or vinyl compound may be used together with a polyimide, a polyamic acid, or a polyamic acid ester, each of which has a radical addition reactive double bond in the molecule or a polyimide precursor having a unit structure of Formula (2).

Here, in the present invention, "(meth)acrylate compound" refers to both an acrylate compound and a methacrylate compound. For example, "(meth)acrylic acid" refers to acrylic acid and methacrylic acid.

Among these, multi-functional compounds such as a (meth)acrylate compound and a vinyl compound, that is, a multi-functional (meth)acrylate compound and a multi-functional vinyl compound can be preferably used, and a multi-functional (meth)acrylate compound can be particularly preferably used.

Examples of multi-functional (meth)acrylate compounds include trimethylolpropane tri(meth)acrylate, ditrimethylolpropane tetra(meth)acrylate, pentaerythritol di(meth)acrylate, pentaerythritol tri(meth)acrylate, pentaerythritol di(meth)acrylate monostearate, pentaerythritol tetra(meth)acrylate, dipentaerythritol penta(meth)acrylate, dipentaerythritol hexa(meth)acrylate, glycerol tri(meth)acrylate, propoxylated glycerol tri(meth)acrylate, ethoxylated trimethylolpropane tri(meth)acrylate, propoxylated trimethylolpropane tri(meth)acrylate, ethoxylated pentaerythritol tetra(meth)acrylate, ethoxylated dipentaerythritol hexa(meth)acrylate, ethoxylated glycerin tri(meth)acrylate, ethoxylated bisphenol A di(meth)acrylate, ethoxylated bisphenol F di(meth)acrylate, 1,3-propanediol di(meth)acrylate, 1,3-butanediol di(meth)acrylate, 1,4-butanediol di(meth)acrylate, 1,6-hexanediol di(meth)acrylate, 2-methyl-1,8-octanediol di(meth)acrylate, 1,9-nonanediol di(meth)acrylate, 1,10-decanediol di(meth)acrylate, neopentyl glycol di(meth)acrylate, ethylene glycol di(meth)acrylate, diethylene glycol di(meth)acrylate, triethylene glycol di(meth)acrylate, tetraethylene glycol di(meth)acrylate, propylene glycol di(meth)acrylate, dipropylene glycol di(meth)acrylate, bis(2-hydroxyethyl)isocyanurate di(meth)acrylate, tris(2-hydroxyethyl)isocyanurate di(meth)acrylate, tris(2-hydroxyethyl)isocyanurate tri(meth)acrylate, tricyclo[5.2.1.0^{2,6}]decane dimethanol di(meth)acrylate, dioxane glycol di(meth)acrylate, 2-hydroxy-1-acryloyloxy-3-methacryloyloxypropane, 2-hydroxy-1,3-di(meth)acryloyloxypropane, 9,9-bis[4-(2-(meth)acryloyloxyethoxy)phenyl]fluorene, bis[4-(meth)acryloylthiophenyl] sulfide, bis[2-(meth)acryloylthioethyl] sulfide, 1,3-adamantanediol di(meth)acrylate, 1,3-adamantanediethanol di(meth)acrylate, polyethylene glycol di(meth)acrylate, polypropylene glycol di (meth)acrylate, tris (2-(meth)acryloyloxyethyl)phosphate, and ε-caprolactone-modified tris(2-hydroxyethyl)isocyanurate tri(meth)acrylate.

In addition, as one type of multi-functional (meth)acrylate compound, a multi-functional urethane (meth)acrylate compound can be used. The compound is a compound that has a plurality of acryloyl groups or methacryloyl groups in one molecule and has one or more urethane bonds (-NHCOO-). Examples of multi-functional urethane (meth)acrylates include those obtained by reacting a multi-functional isocyanate with a (meth)acrylate having a hydroxy group and those obtained by reacting a multi-functional isocyanate with a (meth)acrylate having a hydroxy group and a polyol, but the multi-functional urethane (meth)acrylate compound that can be used in the present invention is not limited to these examples.

Here, examples of multi-functional isocyanates include tolylene diisocyanate, isophorone diisocyanate, xylylene diisocyanate, and hexamethylene diisocyanate.

In addition, examples of (meth)acrylates having a hydroxy group include 2-hydroxyethyl (meth)acrylate, 2-hydroxypropyl (meth)acrylate, pentaerythritol tri(meth)acrylate, dipentaerythritol penta(meth)acrylate, and tripentaerythritol hepta(meth)acrylate.

Here, examples of polyols include diols such as ethylene glycol, propylene glycol, neopentyl glycol, 1,4-butanediol, 1,6-hexanediol, diethylene glycol, and dipropylene glycol; polyester polyols, which are reaction products of these diols and aliphatic dicarboxylic acids such as succinic acid, maleic acid, and adipic acid or dicarboxylic acid anhydrides; polyether polyol; and polycarbonate diol.

Examples of vinyl compounds include the following multi-functional vinyl compounds.
(A1) vinyl hydrocarbons:
   (A1-1) aliphatic vinyl hydrocarbons; isoprene, butadiene, 3-methyl-1,2-butadiene, 2,3-dimethyl-1,3-butadiene, 1,2-polybutadiene, pentadiene, hexadiene, octadiene, and the like
   (A1-2) alicyclic vinyl hydrocarbons; cyclopentadiene, cyclohexadiene, cyclooctadiene, norbornadiene, and the like
   (A1-3) aromatic vinyl hydrocarbons; divinylbenzene, divinyltoluene, divinylxylene, trivinylbenzene, divinylbiphenyl, divinylnaphthalene, divinylfluorene, divinylcarbazole, divinylpyridine, and the like
(A2) vinyl esters, allyl esters, vinyl ethers, allyl ethers, and vinyl ketones:
   (A2-1) vinyl esters; divinyl adipate, divinyl maleate, divinyl phthalate, divinyl isophthalate, divinyl itaconate, vinyl (meth)acrylate, and the like (A2-2) allyl esters; diallyl maleate, diallyl phthalate, diallyl isophthalate, diallyl adipate, allyl (meth)acrylate, and the like
   (A2-3) vinyl ethers; divinyl ether, diethylene glycol divinyl ether, triethylene glycol divinyl ether, and the like
   (A2-4) allyl ethers; diallyl ether, diallyl oxyethane, triallyl oxyethane, tetraallyl oxyethane, tetraallyl oxypropane, tetraallyl oxybutane, tetramethallyl oxyethane, and the like
   (A2-5) vinyl ketones; divinyl ketone, diallyl ketone, and the like
(A3) nitrogen-containing vinyl compound:
   diallylamine, diallyl isocyanurate, diallyl cyanurate, ethoxylated isocyanuric acid di(meth)acrylate, ethoxylated isocyanuric acid tri(meth)acrylate, methylenebis(meth)acrylamide, bismaleimide, and the like
(A4) silicon-containing vinyl compound:
   dimethyldivinylsilane, divinyl(methyl)(phenyl)silane, diphenyldivinylsilane, 1,3-divinyl-1,1,3,3-tetramethyldisilazane, 1,3-divinyl-1,1,3,3-tetraphenyldisilazane, diethoxyvinyl silane, and the like
(A5) fluorine-containing vinyl compound:
   1,4-divinyl perfluorobutane, 1,4-divinyl octafluorobutane, 1,6-divinyl perfluorohexane, 1,6-divinyl dodecafluorohexane, 1,8-divinyl perfluorooctane, 1,8-divinyl hexadecafluorooctane, and the like

Examples of (meth)acrylate compounds and vinyl compounds include the following monofunctional (meth)acrylate compounds and vinyl compounds ((meth)acrylate compounds and vinyl compounds having one radical addition reactive double bond in one molecule).
(C1) (meth)acrylic compound:
   (C1-1) (meth)acrylic acids; (meth)acrylic acid, itaconic acid, 2-trifluoromethylacrylic acid, 2-ethylacrylic acid, 2-propylacrylic acid, 2-bromomethylacrylic acid, 2-acetamidoacrylic acid, 2-ethyl acryloyl chloride, 3,3-dimethyl (meth)acryloyl chloride, and the like
   (C1-2) (meth)acrylic acid esters; methyl (meth)acrylate, ethyl (meth)acrylate, 2-ethoxyethyl (meth)acrylate, 2-butoxyethyl (meth)acrylate, 2-carboxyethyl (meth)acrylate, mono-2-(meth)acryloyloxyethyl succinate, bis[2-(meth)acryloyloxyethyl]phosphate, 2-(meth)acryloyloxyethylacetoacetate, 2-dimethylaminoethyl (meth)acrylate, 2-diethylaminoethyl (meth)acrylate, [2-(meth)acryloyloxyethyl]trimethyl ammonium chloride, 2-isocyanatoethyl (meth)acrylate, 2-[9H-carbazol-9-yl]ethyl (meth)acrylate, vinyl (meth)acrylate, 3-dimethylaminopropyl (meth)acrylate, allyl (meth)acrylate, butyl (meth)acrylate, isobutyl (meth)acrylate, tert-butyl (meth)acrylate, hexyl (meth)acrylate, 2-ethylhexyl (meth)acrylate, 4-tert-butylcyclohexyl (meth)acrylate, isooctyl (meth)acrylate, isodecyl (meth)acrylate, lauryl (meth)acrylate, octadecyl (meth)acrylate, isobornyl (meth)acrylate, tetrahydrofurfuryl (meth)acrylate, (R)-α-(meth)acryloyloxy-β,β-dimethyl-γ-butyrolactone, 2-naphthyl (meth)acrylate, ethylene glycol methylether (meth)acrylate, ethylene glycol cyclopentenyl ether (meth)acrylate, ethylene glycol phenyl ether (meth)acrylate, ethylene glycol (meth)acrylate phosphate, diethylene glycol ethylether (meth)acrylate, diethylene glycol 2-ethylhexylether (meth)acrylate, dipropylene glycol allyl ether (meth)acrylate, neopentyl glycol methylether propoxylate (meth)acrylate, polyethylene glycol methylether (meth)acrylate, polyethylene glycol phenyl ether (meth)acrylate, polypropylene glycol methylether (meth)acrylate, polypropylene glycol 4-nonylphenyl ether (meth)acrylate, ethyl 2-ethylacrylate, benzyl 2-ethylacrylate, ethyl 2-propylacrylate, benzyl 2-propylacrylate, methyl 2-acetamidoacrylate, ethyl cis-2-cyanoacrylate, vinyl crotonate, vinyl cinnamate, isopropyl cinnamate, isobutyl cinnamate, tert-butyl cinnamate, isoamylcinnamate, ethyl 2-cyano-3,3-diphenylacrylate, 2-ethylhexyl 2-cyano-3,3-diphenylacrylate, and the like
   (C1-3) epoxy group-containing (meth)acrylic acid esters; glycidyl (meth)acrylate, and the like
   (C1-4) hydroxy group-containing (meth)acrylic acid esters; 2-hydroxyethyl (meth)acrylate, 2-(4-benzoyl-3-hydroxyphenoxy)ethyl (meth)acrylate, 2-hydroxypropyl 2-(meth)acryloyloxyethyl phthalate, caprolactone 2-(meth)acryloyloxyethyl ester, hydroxypropyl (meth)acrylate, 3-chloro-2-hydroxypropyl (meth)acrylate, 2-hydroxy-3-phenoxypropyl (meth)acrylate, 3-acryloyloxy-2-hydroxypropyl (meth)acrylate, 4-hydroxybutyl (meth)acrylate, polyethylene glycol mono(meth)acrylate, polypropylene glycol mono(meth)acrylate, methyl 3-hydroxy-2-methylenebutyrate, and the like
   (C1-5) halogen-containing (meth)acrylic acid esters; pentabromobenzyl (meth)acrylate, pentabromophenyl (meth)acrylate, methyl 2-bromoacrylate, tert-butyl 2-bromoacrylate, methyl 2-bromomethylacrylate, ethyl 2-bromomethylacrylate, and the like (C1-6) silicon-containing (meth)acrylic acid esters; ethyl 2-trimethylsilylmethylacrylate, 3-trimethoxysilylpropyl (meth)acrylate, 2-trimethylsilyloxyethyl (meth)acrylate, 3-[tris(trimethylsiloxy)silyl]propyl (meth)acrylate, trimethylsilyl (meth)acrylate, and the like
   (C1-7) sulfur-containing (meth)acrylic acid esters; 2-methylthioethyl (meth)acrylate, and the like
(C2) vinyl compound:
   (C2-1) styrenes; styrene, 3-methylstyrene, 4-methylstyrene, 2,4-dimethylstyrene, 2,5-dimethylstyrene, 2,4,6-trimethylstyrene, 3,4-dimethoxystyrene, 4-benzyloxy-3-methoxystyrene, 4-ethoxystyrene, 4-tert-butylstyrene, 4-tert-butoxystyrene, 4-acetoxystyrene, 2-trifluoromethylstyrene, 3-trifluoromethylstyrene, 4-trifluoromethylstyrene, 3,5-bis(trifluoromethyl)styrene, 4-vinyl aniline, 4-vinyl anisole, N,N-dimethylvinyl benzylamine, 4-vinyl biphenyl, 2- fluorostyrene, 3-fluorostyrene, 4-fluorostyrene, 2,6-difluorostyrene, 2,3,4,5,6-pentafluorostyrene, 2-chlorostyrene, 3-chlorostyrene, 4-chlorostyrene, 2,6-dichlorostyrene, 2-bromostyrene, 3-bromostyrene, 4-bromostyrene, 3-nitrostyrene, 3-vinylbenzoic acid, 4-vinylbenzoic acid, tert-butyl 4-vinyl phenyl carbonate, 4-styrenesulfonic acid, 4-vinyl phenylboronic acid, α-methylstyrene, α,2-dimethylstyrene, 1,3-diisopropenylbenzene, 4-chloro-α-methylstyrene, 2,4-diphenyl-4-methyl-1-pentene, 2-isopropenylaniline, 3-isopropenyl-α,α-dimethylbenzylisocyanate, 1-phenyl-1-trimethylsiloxyethylene, α-bromostyrene, 1-vinylnaphthalene, 2-vinylnaphthalene, 9-vinyl anthracene, and the like
   (C2-2) nitrogen-containing heterocyclic vinyl compound; N-vinyl imidazole, 2-vinyl pyridine, 4-vinyl pyridine, 9-vinyl carbazole, 1-vinyl-2-pyrrolidone, N-vinyl phthalimide, N-vinyl caprolactone, and the like
   (C2-3) vinyl esters; vinyl acetate, vinyl trifluoroacetate, vinyl propionate, vinyl pivalate, vinyl decanoate, vinyl neodecanoate, vinyl stearate, vinyl benzoate, and the like
   (C2-4) vinyl ethers; 4-vinyloxymethylcyclohexylmethylbenzoate, ethyl vinyl ether, 2-chloroethyl vinyl ether, propyl vinyl ether, butyl vinyl ether, 4-vinyloxybutylbenzoate, isobutyl vinyl ether, tert-butylvinyl ether, tert-pentyl vinyl ether, cyclohexyl vinyl ether, 2-ethylhexyl vinyl ether, octadecyl vinyl ether, dodecyl vinyl ether, vinyloxytrimethylsilane, 1,4-butanediolvinyl ether, 1,4-cyclohexanedimethanol vinyl ether, ethylene glycol vinyl ether, ethylene glycol butylvinyl ether, diethylene glycolvinyl ether, ethyl 1-propenyl ether, and the like
   (C2-5) Other vinyl compounds; vinylidene chloride, cis-1,3-dichloro-1-propene, 2-methyl-2-vinyloxirane, vinylcyclopentane, vinylcyclohexane, 4-vinyl-1-cyclohexanone, 5-vinyl-2-norbornene, vinyl ferrocene, vinyl trimethylsilane, vinyl trimethoxysilane, N-vinyl formamide, N-methyl-N-vinyl acetamide, vinyl bromide, ethyl vinyl sulfide, methyl vinyl sulfone, vinyl sulfonic acid, vinyl phosphonic acid, trans-4,4'-difluorochalcone, and the like

In addition, the radical addition reactive compound (B) may contain, for example, other addition reactive compounds having one radical addition reactive double bond in the molecule exemplified below. (C3) (meth)acrylamides:
(meth)acrylamide, diacetone (meth)acrylamide, N,N-dimethyl (meth)acrylamide, N-hydroxymethyl (meth)acrylamide, N-tris(hydroxymethyl)methyl (meth)acrylamide, N-butoxymethyl (meth)acrylamide, N-isobutyloxymethyl (meth)acrylamide, N-isopropyl (meth)acrylamide, N-[3-dimethylaminopropyl] (meth)acrylamide, 3-((meth)acryloylamino)propyltrimethyl ammonium chloride, N-tert-butyl (meth)acrylamide, 4-(meth)acryloylmorpholine, N-phenyl (meth)acrylamide, 2-acrylamidoglycolic acid, 2-acrylamido-2-methyl-1-propanesulfonic acid, and the like (C4) (meth)acrylonitriles: (meth)acrylonitrile, 2-chloroacrylonitrile, 1-cyanovinyl acetate, and the like

As the radical addition reactive compound (B), preferably, at least one selected from the group consisting of a polyimide precursor having a transition structure of Formula (2), the multi-functional (meth)acrylate compound and the multi-functional vinyl compound can be used, at least one selected from the group consisting of a polyimide precursor having a unit structure of Formula (2) and the multi-functional (meth)acrylate compound can be used, and a polyimide precursor having a unit structure of Formula (2) is particularly preferable.

In addition, in the radical addition reactive compound (B), the total amount of the monofunctional (meth)acrylate compound, the vinyl compound ((meth)acrylate compounds and vinyl compounds having one radical addition reactive double bond in one molecule), and the other addition reactive compounds added may be 0% by mass to 30% by mass of the total mass of the radical addition reactive compound (B).

In the polymer film-forming composition according to the present invention, regarding the amount of the radical generator (A) and the radical addition reactive compound (B) added, for example, the amount of the radical generator (A) may be 0.1 parts by mass to 20 parts by mass, or 0.5 parts by mass to 10 parts by mass with respect to 100 parts by mass of the radical addition reactive compound (B).

### <<Other components>>

The polymer film-forming composition according to the present invention may further contain components other than the (A) component and the component (B) as long as the effects of the present invention are not impaired.

Examples of other components include hindered phenol compounds, carboxylic acid compounds or anhydrides thereof, solvents, other resin components, crosslinkable compounds, thermal crosslinking agents, adhesive assistants, polymerization inhibitors, azole compounds, and fillers, but the present invention is not limited thereto.

### <Hindered phenol compound>

Examples of hindered phenol compounds include 2,6-di-t-butyl-4-methylphenol, 2,5-di-t-butyl-hydroquinone, octadecyl-3-(3,5-di-t-butyl-4-hydroxyphenyl)propionate, isooctyl-3-(3,5-di-t-butyl-4-hydroxyphenyl)propionate, 4,4'-methylenebis(2, 6-di-t-butylphenol), 4,4'-thio-bis(3-methyl-6-t-butylphenol), 4,4'-butylidene-bis(3-methyl-6-t-butylphenol), triethylene glycol -bis[3-(3-t-butyl-5-methyl-4-hydroxyphenyl)propionate], 1,6-hexanediol-bis[3-(3,5-di-t-butyl-4-hydroxyphenyl)propionate], 2,2-thio-diethylene bis[3-(3,5-di-t-butyl-4-hydroxyphenyl)propionate], N,N'-hexamethylenebis(3,5-di-t-butyl-4-hydroxy-hydrocinnamamide), 2,2'-methylene-bis(4-methyl-6-t-butylphenol), 2,2'-methylene-bis(4-ethyl-6-t-butylphenol), pentaerythritol tetrakis[3-(3,5-di-t-butyl-4-hydroxyphenyl)propionate], tris-(3,5-di-t-butyl-4-hydroxybenzyl)-isocyanurate, 1,3,5-trimethyl-2,4,6-tris(3,5-di-t-butyl-4-hydroxybenzyl)benzene, 1,3, 5-tri s(3-hydroxy-2, 6-dimethyl-4-isopropylbenzyl)-1,3, 5-triazine-2,4, 6-(1H,3H, SH)-tri one, 1,3,5-tris(4-t-butyl-3-hydroxy-2,6-dimethylbenzyl)-1,3,5-triazine-2,4,6-(1H,3H,5H)-trion e, 1,3,5-tris(4-s-butyl-3-hydroxy-2,6-dimethylbenzyl)-1,3,5-triazine-2,4,6-(1H,3H,5H)-trion e, 1,3,5-tris[4-(1-ethylpropyl)-3-hydroxy-2,6-dimethylbenzyl]-1,3,5-triazine-2,4,6-(1H,3H,5 H)-trione, 1,3, 5-tri s [4-triethylmethyl-3-hydroxy-2,6-dimethylbenzyl]-1,3, 5-triazine-2,4, 6-(1H,3H, 5 H)-trione, 1,3,5-tris(3-hydroxy-2,6-dimethyl-4-phenylbenzyl)-1,3,5-triazine-2,4,6-(1H,3H,5H)-trion e, 1,3, 5-tri s(4-t-butyl-3-hydroxy-2, 5, 6-trimethylbenzyl)-1,3, 5-triazine-2,4, 6-(1H,3H, SH)-tri one, 1,3, 5-tri s(4-t-butyl-5-ethyl-3-hydroxy-2, 6-dimethylbenzyl)-1,3, 5-triazine-2,4, 6-(1H,3H, 5 H)-trione, 1,3,5-tris(4-t-butyl-6-ethyl-3-hydroxy-2-methylbenzyl)-1,3,5-triazine-2,4,6-(1H,3H,5H)-t rione, 1,3, 5-tri s(4-t-butyl-6-ethyl-3-hydroxy-2, 5-dimethylbenzyl)-1,3, 5-triazine-2,4, 6-(1H,3H, 5 H)-trione, 1,3,5-tris(4-t-butyl-5,6-diethyl-3-hydroxy-2-methylbenzyl)-1,3,5-triazine-2,4,6-(1H,3H,5 H)-trione, 1,3,5-tris(4-t-butyl-3-hydroxy-2-methylbenzyl)-1,3,5-triazine-2,4,6-(1H,3H,5H)-trione, 1,3, 5-tri s(4-t-butyl-3-hydroxy-2, 5-dimethylbenzyl)-1,3, 5-triazine-2,4, 6-(1H,3H, SH)-trion e, 1,3, 5-tri s(4-t-butyl-5-ethyl-3-hydroxy-2-methylbenzyl)-1,3, 5-triazine-2,4, 6-(1H,3H, SH)-t rione, 1,3,5-tris[(3,5-bis(1,1-dimethylethyl)-4-hydroxyphenyl)methyl]-1,3,5-triazine-2,4,6-(1H, 3H,5H)-trione and the like, but the present invention is not limited thereto.

When the hindered phenol compound is used, the amount thereof added with respect to 100 parts by mass of the radical addition reactive compound (B) may be, for example, 0.1 parts by mass to 20 parts by mass.

### <Carboxylic acid compound or anhydride thereof>

The incorporation of the carboxylic acid compound or anhydride thereof can be expected to stabilize the polyimide precursor having a unit structure of Formula (2) in the radical addition reactive compound (B) in the polymer film-forming composition.

Specific examples of carboxylic acid compounds include the following examples, but the present invention is not limited thereto. In addition, the carboxylic acid compounds exemplified below may be their acid anhydrides.

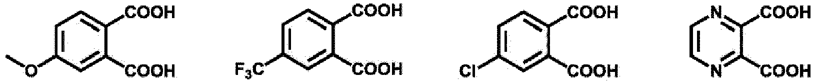

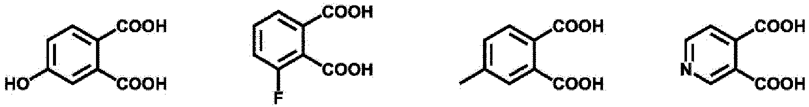

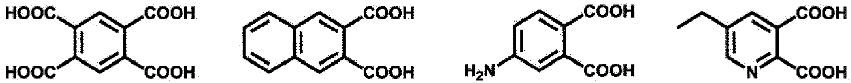

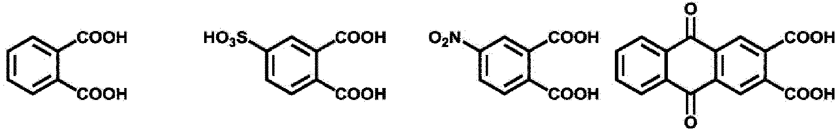

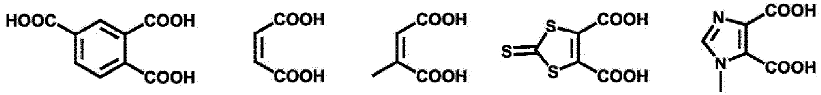

When the carboxylic acid compound or anhydride thereof is used, the amount thereof added may be, for example, 0.1 parts by mass to 10 parts by weight, with respect to 100 parts by mass of the radical addition reactive compound (B).

Here, the carboxylic acid compound or anhydride thereof may be present by being chemically bonded to the radical addition reactive compound (B) and/or a resin component other than the radical addition reactive compound (B) to be described below.

### <Solvent>

As the solvent, it is preferable to use an organic solvent in consideration of the solubility in the radical addition reactive compound (B). Specific examples thereof include N,N-dimethylformamide, N-methyl-2-pyrrolidone, N-ethyl-2-pyrrolidone, N,N-dimethylacetamide, dimethyl sulfoxide, diethylene glycol dimethylether, cyclopentanone, cyclohexanone, γ-butyrolactone, α-acetyl-γ-butyrolactone, tetramethylurea, 1,3-dimethyl-2-imidazolinone, N-cyclohexyl-2-pyrrolidone, and ethyl lactate, and these may be used alone or two or more thereof may be used in combination.

The amount of the solvent used with respect to 100 parts by mass of the radical addition reactive compound (B) may be, for example, in a range of 30 parts by mass to 1,500 parts by mass, or for example, in a range of 100 parts by mass to 1,000 parts by mass depending on a desired film thickness of a film formed from the polymer film-forming composition and the viscosity.

### <Other resin components>

Examples of other resin components include polyoxazoles, polyoxazole precursors, phenolic resins, polyamides, epoxy resins, siloxane resins, acrylic resins, and polyimides other than the radical addition reactive compound (B).

When these other resin components are used, the amount thereof added with respect to 100 parts by mass of the radical addition reactive compound (B) may be, for example, in a range of 0.01 parts by mass to 20 parts by mass.

### <Crosslinkable compound>

As the crosslinkable compound, for example, an isocyanate compound can be used.

Examples of isocyanate compounds include an isocyanate compound of Formula (20). 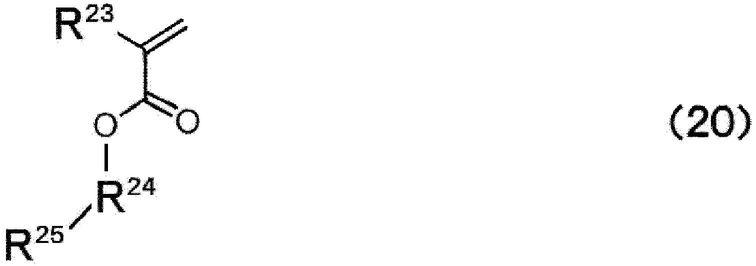 In the formula, R²³ is a hydrogen atom or a methyl group, R²⁴ is a C₁₋₅ alkylene group which may have a substituent or may have an intervening oxygen atom, and R²⁵ is an isocyanate group or a blocked isocyanate group.

In R²⁴, examples of C₁₋₅ alkylene groups include a substituted or unsubstituted methylene group, ethylene group, propylene group, and butylene group. Examples of alkylene groups having an intervening oxygen atom include -CH₂-O-CH₂-, -C₂H₄-O-CH₂-, and -CH₂-O-C₂H₄-. Here, examples of substituents include a halogen atom, an acryloyl group, a methacryloyl group, a nitro group, an amino group, a cyano group, a methoxy group, and an acetoxy group.

R²⁵ is an isocyanate group (-NCO) or a blocked isocyanate group, and the blocked isocyanate group is a group in which an isocyanate group is blocked with a thermally removable protecting group, that is, a group obtained by reacting an isocyanate group with an isocyanate blocking compound (blocking agent).

A blocking agent for an isocyanate group is generally a component that reacts with an isocyanate group, prevents a reaction with functional groups (for example, an acid functional group) in other molecules at room temperature, but is eliminated at a high temperature to regenerate an isocyanate group, and allows a subsequent reaction (for example, with an acid functional group). Examples of blocking agents include alcohols such as methanol, ethanol, isopropanol, n-butanol, 2-ethoxyhexanol, 2-N,N-dimethylaminoethanol, 2-ethoxyethanol, and cyclohexanol, phenols such as phenol, o-nitrophenol, p-chlorophenol, o-cresol, m-cresol, and p-cresol, lactams such as ε-caprolactam, oximes such as acetone oxime, methyl ethyl ketone oxime, methyl isobutyl ketone oxime, cyclohexanone oxime, acetophenone oxime, and benzophenone oxime, nitrogen-containing heteroaryl compounds such as amines, amides, pyrazole, 3,5-dimethylpyrazole, and 3-methylpyrazole, thiols such as dodecanethiol and benzenethiol, active methylene compounds such as malonic acid diester, acetoacetic acid ester, malonic acid dinitrile, acetylacetone, methylene disulfone, dibenzoylmethane, dipivaloylmethane, and acetone dicarboxylate diester, and hydroxamic esters.

The blocking agent that is volatile and evaporates from the composition after elimination is advantageous.

The blocked isocyanate group is, for example, a group of the following formula.

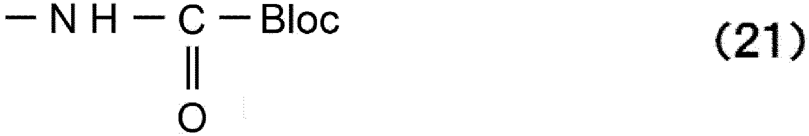

In the formula, Bloc is the residue of an isocyanate blocking compound selected from the group consisting of alcohols, amines, amides, active methylene compounds, nitrogen-containing heteroaryl compounds, oximes, ketoximes, and hydroxamic esters.

Specific examples of isocyanate compounds of Formula (20) include isocyanate-containing (meth)acrylates such as 2-isocyanateethyl methacrylate and 2-isocyanateethylacrylate and compounds obtained by adding a blocking agent such as methyl ethyl ketone oxime, ε-caprolactam, 3,5-dimethylpyrazole, and diethyl malonate to them. Here, these compounds may be used alone or two or more thereof may be used in combination.

In addition, the isocyanate compound can be synthesized by a known method or the following commercially available products can be used: Karenz (registered trademark) AOI (2-isocyanatoethyl acrylate), Karenz AOI-VM (registered trademark) (2-isocyanatoethyl acrylate), Karenz (registered trademark) MOI (2-isocyanatoethyl methacrylate), Karenz (registered trademark) MOI-BM (2-(O-[1'-methylpropylideneamino]carboxyamino)ethyl methacrylate), Karenz (registered trademark) MOI-BP (2-[ (3,5-dimethylpyrazolyl)carbonylamino]ethyl methacrylate), Karenz (registered trademark) MOI-EG (2-(2-methacryloyloxyethyloxy)ethyl isocyanate), Karenz (registered trademark) BEI (1, 1 -(bis(acryloyloxy)methyl)ethylisocyanate), Karenz (registered trademark) AOI-BM (2-(O-[1'-methyl propylidene amino]carboxyamino)ethylacrylate) (all are commercially available from Showa Denko K.K.), and the like.

In addition, an isocyanate compound having a blocked isocyanate group having the following structure can be used.

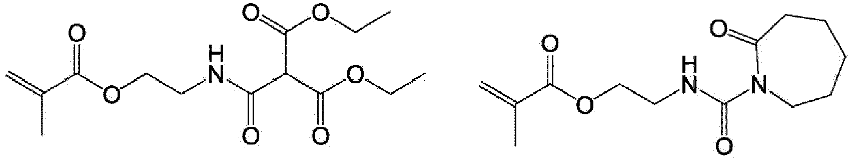

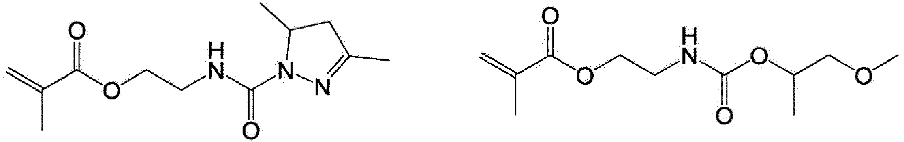

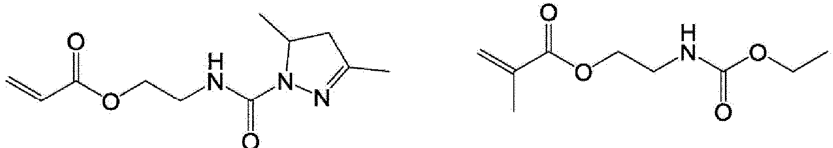

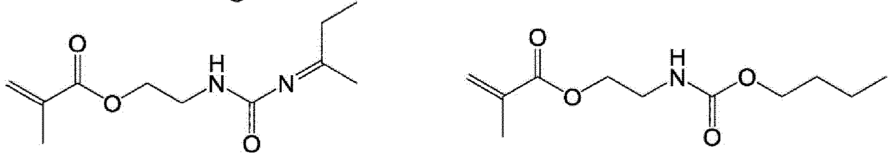

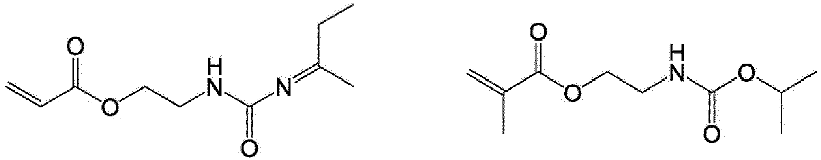

When the isocyanate compound is used, the amount thereof added with respect to 100 parts by mass of the radical addition reactive compound (B) may be, for example, 1 part by mass to 50 parts by mass.

### <Thermal crosslinking agent>

Examples of thermal crosslinking agents include hexamethoxymethylmelamine, tetramethoxy methylglycoluril, tetramethoxymethylbenzoguanamine, 1,3,4,6-tetrakis(methoxymethyl)glycoluril, 1,3,4,6-tetrakis(butoxymethyl)glycoluril, 1,3,4,6-tetrakis(hydroxymethyl)glycoluril, 1,3-bis(hydroxymethyl)urea, 1, 1,3,3-tetrakis(butoxymethyl)urea and 1, 1,3,3-tetrakis(methoxymethyl)urea.

### <Adhesive assistant>

Examples of adhesive assistants include silane coupling agents such as γ-aminopropyldimethoxysilane, N-(β-aminoethyl)-γ-aminopropylmethyldimethoxysilane, γ-glycidoxypropylmethyldimethoxysilane, γ-mercaptopropylmethyldimethoxysilane, 3-methacryloxypropyldimethoxymethylsilane, 3-methacryloxypropyltrimethoxysilane, dimethoxymethyl-3-piperidinopropylsilane, diethoxy-3-glycidoxypropylmethylsilane, N-(3-diethoxymethylsilylpropyl)succinimide, N-[3-(triethoxymethylsilyl)propyl]phthalamic acid, benzophenone-3,3'-bis(N-[3-triethoxysilyl]propylamide)-4,4'-dicarboxylic acid, benzene-1,4-bis(N-[3-triethoxysilyl]propylamide)-2,5-dicarboxylic acid, 3-(triethoxysilyl)propylsuccinic anhydride, and N-phenylaminopropyltrimethoxysilane, and aluminum-based adhesive assistants such as tris(ethylacetoacetate) aluminum, tris(acetylacetonate) aluminum, and ethyl acetoacetate aluminum diisopropylate.

When the adhesive assistant is used, the amount thereof added with respect to 100 parts by mass of the radical addition reactive compound (B) may be, for example, in a range of 0.5 parts by mass to 25 parts by mass.

### <Polymerization inhibitor>

As the thermal polymerization inhibitor, for example, hydroquinone, N-nitrosodiphenylamine, p-tert-butylcatechol, phenothiazine, N-phenylnaphthylamine, ethylenediaminetetraacetic acid, 1,2-cyclohexanediaminetetraacetic acid, glycol ether diaminetetraacetic acid, 2,6-di-tert-butyl-p-methylphenol, 5-nitroso-8-hydroxyquinoline, 1-nitroso-2-naphthol, 2-nitroso-1-naphthol, 2-nitroso-5-(N-ethyl-N-sulfopropylamino)phenol, N-nitroso-N-phenylhydroxyamine ammonium salt, N-nitroso-N (1-naphthyl)hydroxyamine ammonium salt and the like are used.

When the thermal polymerization inhibitor is used, the amount thereof added with respect to 100 parts by mass of the radical addition reactive compound (B) may be in a range of 0.005 parts by mass to 12 parts by mass.

### <Azole compound>

Examples of azole compounds include 1H-triazole, 5-methyl-1H-triazole, 5-ethyl-1H-triazole, 4,5-dimethyl-1H-triazole, 5-phenyl-1H-triazole, 4-t-butyl-5-phenyl-1H-triazole, 5-hydroxyphenyl-1H-triazole, phenyltriazole, p-ethoxyphenyltriazole, 5-phenyl-1-(2-dimethylaminoethyl)triazole, 5-benzyl-1H-triazole, hydroxyphenyltriazole, 1,5-dimethyltriazole, 4,5-diethyl-1H-triazole, 1H-benzotriazole, 2-(5-methyl-2-hydroxyphenyl)benzotriazole, 2-[2-hydroxy-3,5-bis(α,α-dimethylbenzyl)phenyl]-benzotriazole, 2-(3,5-di-t-butyl-2-hydroxyphenyl)benzotriazole, 2-(3-t-butyl-5-methyl-2-hydroxyphenyl)-benzotriazole, 2-(3, 5-di-t-amyl-2-hydroxyphenyl)benzotri azole, 2-(2'-hydroxy-5'-t-octylphenyl)benzotriazole, hydroxyphenylbenzotriazole, tolyltriazole, 5-methyl-1H-benzotriazole, 4-methyl-1H-benzotriazole, 4-carboxy-1H-benzotriazole, 5-carboxy-1H-benzotriazole, 1H-tetrazole, 5-methyl-1H-tetrazole, 5-phenyl-1H-tetrazole, 5-amino-1H-tetrazole, and 1-methyl-1H-tetrazole. These azole compounds may be used alone or two or more thereof may be used in combination.

When the azole compound is used, the amount thereof added with respect to 100 parts by mass of the radical addition reactive compound (B) may be, for example, 0.1 parts by mass to 20 parts by mass, or for example, 0.5 parts by mass to 5 parts by mass.

### <Filler>

The filler may be, for example, an inorganic filler, and specifically, may be a sol of silica, aluminum nitride, boron nitride, zirconia, alumina or the like.

### [Selective polymer film-forming method]

The selective polymer film-forming method according to the present invention is a method including forming a polymer film on a substrate having a surface including a region (R-I) made of a metal (I) and a region (R-II) that is adjacent to the region (R-I) and made of a material (II) different from the metal (I) using the polymer film-forming composition. Specific examples of the substrate and polymer film-forming composition used in this method are as described above.

Specifically, this method includes a polymer film forming step in which a polymer film-forming composition containing a radical generator (A) and a radical addition reactive compound (B) is applied to the surface of the substrate and heated to form a polymer film and subsequently a step in which the surface of the substrate is brought into contact with a solvent (C), and a coating on the region (R-II) is removed.

### <Polymer film forming step>

In this step, the polymer film-forming composition according to the present invention is applied onto the substrate and then dried and heated as necessary to form a polymer film.

As a method of applying a polymer film-forming composition to a substrate, for example, an application method using a spin coater, a bar coater, a blade coater, a curtain coater, a screen printing machine or the like, and a method of spray coating using a spray coater can be used.

After application, as a drying method that can be performed as necessary, for example, air drying, heat drying in an oven or on a hot plate, vacuum drying or the like is used.

The heating conditions can be appropriately selected from among, for example, a temperature of 50°C to 200°C and a time of 10 seconds to 600 seconds.

Radicals are generated from the radical generator (A) by heating, the radicals react with the radical addition reactive compound (B) to proceed a radical addition reaction, and the radical addition reactive compound (B) is crosslinked. According to crosslinking, the coating film is cured. In the present invention, curability is a property of being cured, and high curability means that it is easily cured (easily crosslinked). As described above, in the present invention, the curability of the polymer film-forming composition is different between the region (R-I) and the region (R-II), that is, in one aspect, the polymer film-forming composition is composed of a component composition that has a higher curability on the region (R-I) than on the region (R-II) when heated on the substrate. Due to such a difference in curability, in the step of removing the polymer film to be described below, only the coating on the region (R-II) can be selectively removed.

The film thickness of the polymer film obtained in this step is not particularly limited, and may be, for example, 1 nm to 50 µm, 50 nm to 10 µm, or 100 nm to 5 µm.

### <Step of removing polymer film on region (R-II)>

This step is a step in which the surface of the substrate on which the polymer film is formed is brought into contact with the solvent (C), and a coating on the region (R-II) is removed.

A method of bringing the substrate surface into contact with the solvent (C) is not particularly limited, and any method selected from among a rotary spray method, a paddle method, an immersion method and the like can be performed.

As the solvent (C) used here, any solvent generally used in a semiconductor producing step, for example, N-methyl-2-pyrrolidone, N-ethyl-2-pyrrolidone, N-cyclohexyl-2-pyrrolidone, N,N-dimethylacetamide, cyclopentanone, cyclohexanone, propylene glycol monomethyl ether, propylene glycol monomethyl ether acetate, ethyl lactate, γ-butyrolactone, α-acetyl-γ-butyrolactone, methyl 2-hydroxyisobutyrate, and the like can be used. In addition, two or more types, for example, several types of solvents, may be used in combination.

### <Residue removal step>

In addition, the method may include a residue removal step in which the residue on the region (R-II) is removed by dry etching after the step of removing the coating on the region (R-II).

The dry etching in this step can be performed using, for example, an oxygen-based gas (an oxygen gas, an oxygen/carbonyl sulfide (COS) mixed gas, etc.) and a nitrogen gas or an argon gas can be used in combination as a dilution gas.

When the selective polymer film-forming method according to the present invention is performed, a polymer film composed of the polymer film-forming composition is formed only on the region (R-I) made of a metal (I) within the surface of the substrate, that is, a laminate (substrate) having a polymer film only on the region (R-I) and having no polymer film on the region (R-II) can be obtained. The laminate is within the scope of the present invention.

### [Thin film-forming method]

The substrate having a polymer film only on the region (R-I) obtained by the above [Selective polymer film-forming method] can be suitably used for region-selective film formation on a substrate surface using the atomic layer deposition method (ALD method).

That is, the present invention provides a thin film-forming method including selectively forming, on a substrate having a region (R-I) made of a metal (I) and a region (R-II) made of a material (II) different from the metal (I), a thin film on the region (R-II) by an atomic layer deposition method, and the thin film-forming method includes a step of forming a thin film by an atomic layer deposition method on the surface of the substrate on which a polymer film is formed on the region (R-I) by the selective polymer film-forming method.

In addition, the thin film-forming method may further include a step of removing the polymer film on the region (R-I) made of a metal (I) after the step of forming the thin film.

For procedures, gas species used, and the like in the film-forming method by the atomic layer deposition method (ALD method), known procedures and the like in the ALD method can be used.

### [Examples]

Hereinafter, the present invention will be described in more detail with reference to examples and comparative examples, but the present invention is not limited to these examples.

The weight average molecular weight shown in the following synthesis examples in this specification is the result measured by gel permeation chromatography (hereinafter abbreviated as GPC in this specification). The measurement was performed using a GPC device (HLC-8320GPC, commercially available from Tosoh Corporation), and the measurement conditions and the like are as follows.
GPC column: KD-803, KD-805 (commercially available from Shodex)
Column temperature: 50°C
Solvent: N,N-dimethylformamide (special grade, commercially available from Kanto Chemical Co., Inc.), lithium bromide monohydrate (super special grade, commercially available from Kanto Chemical Co., Inc.) (30 mM)/ phosphoric acid (commercially available from Aldrich) (30 mM)/tetrahydrofuran (special grade, commercially available from Kanto Chemical Co., Inc.) (1%)
Flow rate: 1.0 mL/min
Standard sample: polystyrene (commercially available from GL Sciences Inc.)

### <Production Example 1> synthesis of dicarboxylic acid diester (1)

200.00 g (0.68 mol) of 4,4'-biphthalic dianhydride (commercially available from Tokyo Chemical Industry Co., Ltd.) was put into a 2 L four-neck flask, 176.92 g (1.366 mol) of 2-hydroxyethyl methacrylate (commercially available from Aldrich), 0.74 g (0.007 mol) of hydroquinone (commercially available from Tokyo Chemical Industry Co., Ltd.), and 600 g of γ-butyrolactone (super special grade, commercially available from Kanto Chemical Co., Inc.) were added, the mixture was stirred at 23°C, 108.63 g (1.36 mol) of pyridine (commercially available from Kanto Chemical Co., Inc., dehydrated) was added, the temperature was then raised to 50°C, and the mixture was stirred at 50°C for 2 hours to obtain a solution containing a compound of the following Formula (A).

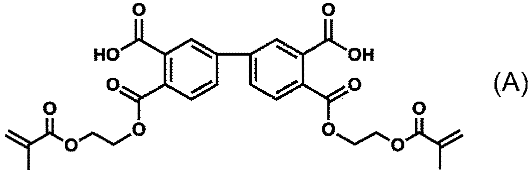

### <Production Example 2> Synthesis of polymer (2) as polyimide precursor

82.46 g of the solution containing the compound prepared in Production Example 1 and 19.45 g of γ-butyrolactone were put into a 500 ml four-neck flask, and while stirring the solution at about 5°C, a solution obtained by dissolving 13.13 g of N,N'-diisopropylcarbodiimide (DIC) (commercially available from Tokyo Chemical Industry Co., Ltd.) in 30 g of γ-butyrolactone was added dropwise to the reaction solution over 0.5 hours, and after dropwise addition, the mixture was additionally stirred for 0.5 hours. Subsequently, with stirring, a solution obtained by dissolving 19.68 g of 2,2-bis[4-(4-aminophenoxy)phenyl]propane (commercially available from Tokyo Chemical Industry Co., Ltd.) in 30 g of N-methyl-2-pyrrolidinone (super special grade, commercially available from Kanto Chemical Co., Inc.) was added dropwise over 2 hours. Then, the temperature was raised to about 25°C, and the mixture was additionally stirred for 6 hours, 4.5 g of ethanol (special grade, commercially available from Kanto Chemical Co., Inc.) was then added, and the mixture was stirred for 1 hour.

The obtained reaction mixture was added to 1,500 g of methanol (special grade, commercially available from Kanto Chemical Co., Inc.) to produce a precipitate composed of a crude polymer. The supernatant liquid was separated from the crude polymer by decantation, 150.0 g of N-methyl-2-pyrrolidinone was then added to dissolve the precipitate, and thereby a crude polymer solution was obtained. The obtained crude polymer solution was added dropwise to 2,250 g of water to precipitate a polymer, the obtained precipitate was filtered off, and the filtered product was then washed twice with 600 g of methanol, and vacuum-dried to obtain a powder polymer. The molecular weight of the polymer was measured by GPC (in terms of polystyrene standards), and the weight average molecular weight (Mw) was 8,016. The yield was 73.6%. The polymer had a repeating unit structure of the following Formula (B).

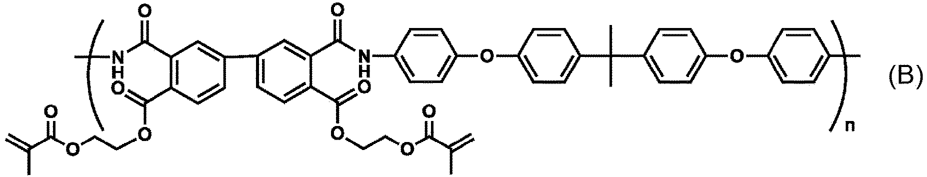

### <Example 1>

0.73 g of the polymer obtained in Production Example 2, 0.04 g of IRGACURE [registered trademark] OXE01 (photopolymerization initiator, commercially available from BASF), 0.22 g of A-DPH-12E (ethoxylated dipentaerythritol polyacrylate, commercially available from Shin-Nakamura Chemical Co., Ltd.), 0.01 g of IRGANOX [registered trademark] 3114 (hindered phenol-based antioxidant, commercially available from BASF), and 0.007 g of phthalic acid (commercially available from Tokyo Chemical Industry Co., Ltd.) were dissolved in a mixed solvent containing 1.79 g of N-ethyl-2-pyrrolidone, 5.40 g of cyclopentanone, and 1.80 g of ethyl lactate to prepare a composition. Then, the resulting product was filtered using a polypropylene microfilter having a pore size of 5 µm to prepare a polymer film-forming composition 1.

### <Example 2>

0.94 g of trimethylolpropane triacrylate [registered trademark] A-TMPT (multifunctional acrylate, commercially available from Shin-Nakamura Chemical Co., Ltd.) and 0.06 g of IRGACURE [registered trademark] OXE01 (photopolymerization initiator, commercially available from BASF) were dissolved in a mixed solvent containing 6.30 g of N-ethyl-2-pyrrolidone and 2.70 g of cyclopentanone to prepare a composition. Then, the resulting product was filtered using a polypropylene microfilter having a pore size of 5 µm to prepare a polymer film-forming composition 2.

### <Comparative Example 1>

0.94 g of trimethylolpropane triacrylate [registered trademark] A-TMPT (multifunctional acrylate, commercially available from Shin-Nakamura Chemical Co., Ltd.) was dissolved in a mixed solvent containing 6.30 g of N-ethyl-2-pyrrolidone and 2.70 g of cyclopentanone to prepare a composition. Then, the resulting product was filtered using a polypropylene microfilter having a pore size of 5 µm to prepare a polymer film-forming composition 3.

### <Film Formation Example 1>

A substrate with a SiO₂ surface was immersed in a 10% sulfuric acid aqueous solution at room temperature for 1 minute. Then, the substrate was washed with pure water and ethanol, and dried by nitrogen blowing. Subsequently, the polymer film-forming composition 1 prepared in Example 1 was applied onto the substrate using a spin coater and baked at 130°C for 1 minute.

### <Film Formation Example 2>

A substrate with a Cu surface was immersed in a 10% sulfuric acid aqueous solution at room temperature for 1 minute. Then, the substrate was washed with pure water and ethanol, and dried by nitrogen blowing. Subsequently, the polymer film-forming composition 1 prepared in Example 1 was applied onto the substrate using a spin coater and baked at 130°C for 1 minute.

### <Film Formation Example 3>

A substrate on which 0.5 µm and 10 µm Cu and SiO₂ lines were alternately formed was immersed in a 10% sulfuric acid aqueous solution at room temperature for 1 minute. Then, the substrate was washed with pure water and ethanol, and dried by nitrogen blowing. Subsequently, the polymer film-forming composition 1 prepared in Example 1 was applied onto the substrate using a spin coater and baked at 130°C for 1 minute.

Then, the substrate was washed with cyclopentanone (CYP), and finally the residue was removed by dry etching. The etcher and etching conditions used for dry etching were as follows.
RIE-200NL (commercially available from SAMCO Inc.), etching gas: O₂, flow rate: 5 sccm, RF output: 100 W, pressure: 5 Pa, discharge time: 10 Pa

### <Film Formation Example 4>

A substrate with a SiO₂ surface was immersed in a 10% sulfuric acid aqueous solution at room temperature for 1 minute. Then, the substrate was washed with pure water and ethanol, and dried by nitrogen blowing. Subsequently, the polymer film-forming composition 2 prepared in Example 2 was applied onto the substrate using a spin coater and baked at 130°C for 1 minute.

### <Film Formation Example 5>

A substrate with a Cu surface was immersed in a 10% sulfuric acid aqueous solution at room temperature for 1 minute. Then, the substrate was washed with pure water and ethanol, and dried by nitrogen blowing. Subsequently, the polymer film-forming composition 2 prepared in Example 2 was applied onto the substrate using a spin coater and baked at 130°C for 1 minute.

### <Film Formation Example 6>

A substrate with a SiO₂ surface was immersed in a 10% sulfuric acid aqueous solution at room temperature for 1 minute. Then, the substrate was washed with pure water and ethanol, and dried by nitrogen blowing. Subsequently, the polymer film-forming composition 3 prepared in Comparative Example 1 was applied onto the substrate using a spin coater and baked at 130°C for 1 minute.

### <Film Formation Example 7>

A substrate with a Cu surface was immersed in a 10% sulfuric acid aqueous solution at room temperature for 1 minute. Then, the substrate was washed with pure water and ethanol, and dried by nitrogen blowing. Subsequently, the polymer film-forming composition 3 prepared in Comparative Example 1 was applied onto the substrate using a spin coater and baked at 130°C for 1 minute.

### [Substrate Selectivity Evaluation 1]

The substrates produced in Film Formation Examples 1 and 2 were washed with cyclopentanone (CYP), the appearance was then visually checked and it was checked whether any film remained on the substrate. The results are shown in Table 1.

### [Substrate Selectivity Evaluation 2]

For the substrates produced in Film Formation Examples 1 and 2 and the substrates used in Substrate Selectivity Evaluation 1 (substrates produced in Film Formation Examples 1 and 2 that were washed with cyclopentanone (CYP)), a contact angle of a water droplet was measured by a liquid drop method using a contact angle meter [product number: CA-W150, commercially available from Kyowa Interface Science Co., Ltd.]. The results are shown in Table 1.

Here, in the liquid drop method, at room temperature, a 3 µL water droplet was brought into contact with the substrate, and the contact angle was measured after 3 seconds, 5 seconds, and 7 seconds. Each measurement was performed three times and the average value thereof was used.

**[Table 1]**

| | | Film Formation Example 1 (SiO₂ surface) | | Film Formation Example 2 (Cu surface) | |
|---|---|---|---|---|---|
| | Washing with CYP | Yes | No | Yes | No |
| Appearance check (visually) | | No film | - | Film | - |
| Contact angle (°) | | 41 | 66 | 67 | 68 |

As shown in Table 1, in the substrate that was coated with the polymer film-forming composition 1 prepared in Example 1 and baked, when the substrate had a Cu surface (Film Formation Example 2), it was visually confirmed that the film remained after washing with cyclopentanone (CYP). However, when the substrate had a SiO₂ surface (Film Formation Example 1), it was visually confirmed that no film remained after washing with cyclopentanone (CYP).

In addition, when the substrate had a SiO₂ surface (Film Formation Example 1), the contact angle changed significantly before and after washing with cyclopentanone (CYP). This result reflects the fact that the surface condition of the substrate changed significantly after washing with CYP, that is, the film formed from the polymer film-forming composition 1 disappeared after washing with CYP.

On the other hand, when the substrate had a Cu surface (Film Formation Example 2), the contact angle hardly changed before and after washing with cyclopentanone (CYP), and both cases showed a high contact angle. This result reflects the fact that the surface condition of the substrate was not changed after washing with CYP, that is, the film formed from the polymer film-forming composition 1 remained.

Based on these results, it was confirmed from the contact angle measurement results that, when a film was formed using the polymer film-forming composition 1 prepared in Example 1, if the substrate had a Cu surface, the film remained after washing with CYP, and if the substrate had a SiO₂ surface, the film disappeared.

### [Substrate Selectivity Evaluation 3]

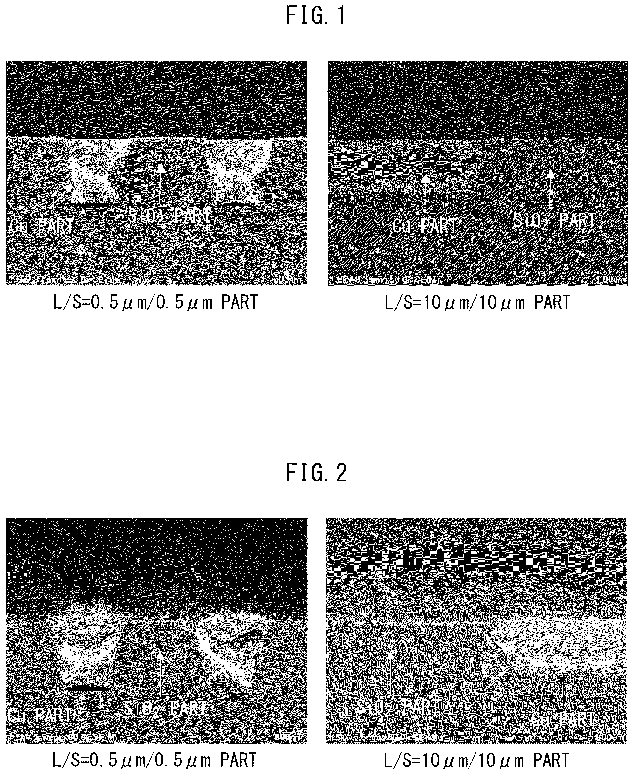

For an untreated substrate in which Cu and SiO₂ lines were alternately formed used in Film Formation Example 3 and a substrate produced in Film Formation Example 3 (a substrate that was coated with the polymer film-forming composition 1, baked, washed with CYP and subjected to dry etching processing), the vertical cross section of the substrate was observed under a scanning electron microscope (SEM, Regulus (registered trademark) 8240, commercially available from Hitachi High-Tech Corporation). FIG. 1 shows the observation results for the untreated substrate, and FIG. 2 shows the observation results for the substrate produced in Film Formation Example 3.

As shown in FIG. 1, it was confirmed that the top of the Cu part of the untreated substrate was lower than the top of the adjacent SiO₂ part. Here, as shown in FIG. 2, it was confirmed that, in the substrate treated using the polymer film-forming composition 1 prepared in Example 1 (the substrate produced in Film Formation Example 3), a film was formed on the Cu part, which was higher than (raised from) the top of the adjacent SiO₂ part.

### [Substrate Selectivity Evaluation 4]

The substrates produced in Film Formation Examples 4 to 7 were washed with propylene glycol monomethyl ether acetate (PGMEA), the appearance was then visually checked and it was checked whether any film remained on the substrate. The results are shown in Table 2.

**[Table 2]**

| | Polymer film-forming composition 2 | | Polymer film-forming composition 3 | |
|---|---|---|---|---|
| | Film Formation Example 4 (SiO₂ surface) | Film Formation Example 5 (Cu surface) | Film Formation Example 6 (SiO₂ surface) | Film Formation Example 7 (Cu surface) |
| Appearance check (visually) | No film | Film | No film | No film |

As shown in Table 2, in the substrate that was coated with the polymer film-forming composition 2 prepared in Example 2 and baked, when the substrate had a Cu surface (Film Formation Example 5), it was visually confirmed that the film remained even after washing with propylene glycol monomethyl ether acetate (PGMEA), and when the substrate had a SiO₂ surface (Film Formation Example 4), it was visually confirmed that no film remained after washing with propylene glycol monomethyl ether acetate (PGMEA).

On the other hand, in the substrate that was coated with the polymer film-forming composition 3 prepared in Comparative Example 1 and baked, when the substrate had a Cu surface (Film Formation Example 7), it was visually confirmed that no film remained after washing with propylene glycol monomethyl ether acetate (PGMEA), and when the substrate had a SiO₂ surface (Film Formation Example 6), it was visually confirmed that no film remained after washing with propylene glycol monomethyl ether acetate (PGMEA).

Accordingly, based on the results of Substrate Selectivity Evaluations 1 to 4, it was confirmed that, when the polymer film-forming composition 1 and the polymer film-forming composition 2 prepared in Example 1 and Example 2 were used, it was possible to selectively form a film depending on the type (material) of the substrate surface on which the film was formed, that is, it was possible to form a film position-selectively depending on the material of the underlying substrate surface.

### INDUSTRIAL APPLICABILITY

According to the polymer film-forming composition of the present invention, it is possible to selectively form a polymer film depending on a material of a substrate surface.

## Claims

1. A polymer film-forming composition for selectively forming, on a substrate having a surface including a region (R-I) made of a metal (I) and a region (R-II) made of a material (II) different from the metal (I), a polymer film on the region (R-I) of the substrate,
wherein the polymer film-forming composition contains a radical generator (A) and a radical addition reactive compound (B).

2. A polymer film-forming composition for selectively forming, on a substrate having a surface including a region (R-I) made of a metal (I) and a region (R-II) made of a material (II) different from the metal (I), a polymer film on the region (R-I) of the substrate,
wherein the polymer film-forming composition contains a radical generator (A) and a radical addition reactive compound (B), and
wherein the polymer film-forming composition is composed of a component composition having a higher curability on the region (R-I) than on the region (R-II) when heated on the substrate.

3. The polymer film-forming composition according to claim 1 or 2,
wherein the radical generator (A) is a radical generator containing a sulfur atom.

4. The polymer film-forming composition according to any one of claims 1 to 3,
wherein the radical generator (A) is an oxime ester-based radical generator.

5. The polymer film-forming composition according to any one of claims 1 to 4,
wherein the radical generator (A) is a radical generator of the following Formula (1): 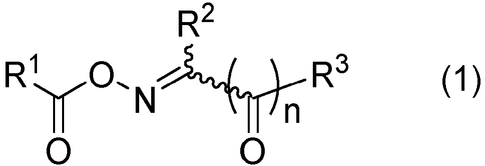 [wherein,
each of R¹ and R³ is independently a substitutable phenyl group, a substitutable 5-to 10-membered aromatic heterocyclic group, a substitutable C₁₋₁₀ alkyl group, and a substituent for the phenyl group, aromatic heterocyclic group, or alkyl group arbitrarily contains a sulfur atom,
R² is a hydrogen atom or a substitutable C₁₋₁₀ alkyl group, and a substituent for the alkyl group arbitrarily contains a sulfur atom,
n is 0 or 1, and
a wavy line indicates either an E geometrical isomer or a Z geometrical isomer, or a mixture of the E geometrical isomer and the Z geometrical isomer].

6. The polymer film-forming composition according to any one of claims 1 to 5,
wherein the radical addition reactive compound (B) is at least one polymer selected from the group consisting of a polyimide, a polyamic acid, and a polyamic acid ester, each of which has a radical addition reactive double bond in a molecule.

7. The polymer film-forming composition according to any one of claims 1 to 6,
wherein the radical addition reactive compound (B) is at least one selected from among polyimide precursors having a unit structure of the following Formula (2): 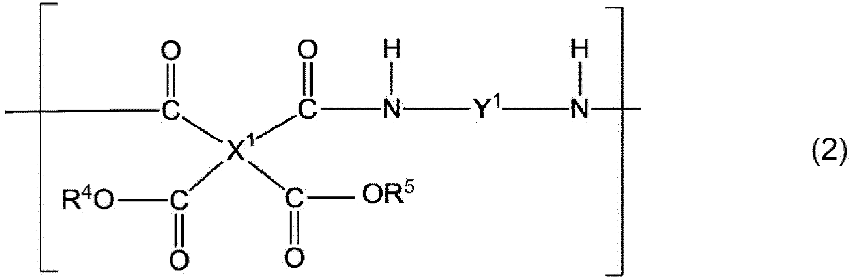 [wherein,
X¹ is a tetravalent organic group, and Y¹ is a divalent organic group, and
each of R⁴ and R⁵ is independently a hydrogen atom or a monovalent organic group, provided that at least one of R⁴ and R⁵ is a group of Formula (3)] 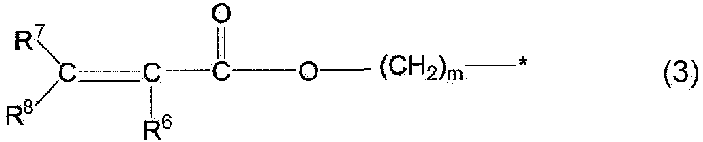 [wherein,
each of R⁶, R⁷ and R⁸ is independently a hydrogen atom or a C₁₋₃ monovalent organic group, m is an integer of 1 to 10, and * indicates a bonding site with an oxygen atom in Formula (2)].

8. The polymer film-forming composition according to any one of claims 1 to 5,
wherein the radical addition reactive compound (B) is at least one selected from the group consisting of a (meth)acrylate compound and a vinyl compound.

9. The polymer film-forming composition according to any one of claims 1 to 8,
wherein the metal (I) is copper, an alloy containing copper, titanium or an alloy containing titanium.

10. The polymer film-forming composition according to any one of claims 1 to 9,
wherein the material (II) is at least one selected from the group consisting of SiO₂, SiN, SiC, SiOC, SiCN, Ta, TaN, Ti, and TiN.

11. A selective polymer film-forming method in which a polymer film is formed on a surface of a substrate, the surface having a region (R-I) made of a metal (I) and a region (R-II) that is adjacent to the region (R-I) and made of a material (II) different from the metal (I), the selective polymer film-forming method comprising:
a polymer film forming step in which a polymer film-forming composition containing a radical generator (A) and a radical addition reactive compound (B) is applied to the surface and heated to form a polymer film; and subsequently
a step in which the surface of the substrate is brought into contact with a solvent (C), and a coating on the region (R-II) is removed.

12. The selective polymer film-forming method according to claim 11, further comprising a residue removal step in which a residue on the region (R-II) is removed by dry etching after the step of removing the coating on the region (R-II).

13. A thin film-forming method of selectively forming, on a substrate having a region (R-I) made of a metal (I) and a region (R-II) made of a material (II) different from the metal (I), a thin film on the region (R-II) by an atomic layer deposition method, the thin film-forming method comprising:
a step of forming a thin film by an atomic layer deposition method on the surface of the substrate on which a polymer film is formed on the region (R-I) by the selective polymer film-forming method according to claim 11 or 12.

14. The thin film-forming method according to claim 13, further comprising a step of removing the polymer film on the region (R-I) made of the metal (I) after the step of forming the thin film.

15. A laminate having a plurality of regions formed on a surface of a substrate,
wherein each of the regions has a region (R-I) made of a metal (I) and a region (R-II) that is adjacent to the region (R-I) and made of a material (II) different from the metal (I),
wherein a polymer film formed from the polymer film-forming composition according to any one of claims 1 to 10 is provided on the region (R-I), and
wherein the polymer film is not provided on the region (R-II).
